(19) **Europäisches Patentamt / European Patent Office / Office européen des brevets**

(11) **EP 4 439 555 A1**

(12) # EUROPEAN PATENT APPLICATION

(43) Date of publication:
**02.10.2024 Bulletin 2024/40**

(21) Application number: **23165194.4**

(22) Date of filing: **29.03.2023**

(51) International Patent Classification (IPC):
**G10L 21/02** (2013.01)  **G10L 25/30** (2013.01)
**H03M 7/30** (2006.01)  **G06N 3/045** (2023.01)

(52) Cooperative Patent Classification (CPC):
**G10L 25/30; G06N 3/045; G10L 21/02;**
G10L 21/0208; G10L 21/038; G10L 2021/02082;
H03M 7/3059; H03M 7/3066

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Fraunhofer-Gesellschaft zur Förderung der angewandten Forschung e.V.**
**80686 München (DE)**

(72) Inventors:
• **CHAKRABARTY, Soumitro**
**91058 Erlangen (DE)**
• **SHETU, Shrishti Saha**
**91058 Erlangen (DE)**
• **MABANDE, Edwin**
**91058 Erlangen (DE)**
• **THIERGART, Oliver**
**91058 Erlangen (DE)**

(74) Representative: **Zinkler, Franz et al Schoppe, Zimmermann, Stöckeler Zinkler, Schenk & Partner mbB Patentanwälte Radlkoferstrasse 2 81373 München (DE)**

(54) **APPARATUS, METHOD OR COMPUTER PROGRAM FOR PROCESSING AN INFORMATION SIGNAL USING A COMPRESSION OF A DYNAMIC RANGE**

(57)    An apparatus for processing an information signal, comprises: a feature extractor (100) for extracting a set of features from the information signal, wherein the feature extractor (100) comprises: a raw feature calculator (110) for calculating raw feature results, each raw feature result having at least two raw feature components; and a raw feature compressor (120) for performing a compression of a dynamic range to the at least two raw feature components to obtain at least two compressed raw feature components for each raw feature result, wherein the set of features comprises the compressed raw feature components; and a signal processor (600) for processing the set of features to obtain the processed information signal, wherein the information signal comprises an audio signal, an image signal, or a radar signal.

information signal
(audio signal,
image signal,
radar signal)

| feature extractor |
| raw feature calculator — 110 |
| 1st component (mag., real part…)    2nd component (phase, imaginary part…) — 100 |
| raw feature compressor — 120 |
| compressed components |

signal processor
(e.g. one or more neural networks,
feature segmenter, combiner,
post-processor, …) — 600

processed
information signal

Fig. 1b

**Description**

The present invention relates to information signal processing and, specifically, information signal processing using neural networks.

Deep learning (DL) based solutions for different problems in the field of audio processing have recently become common and shown improved performance over classical signal processing based methods. However, one of the main issues with most of the developed methods is their complexity, both computational as well as memory, which makes them unsuitable for deployment on embedded devices which generally come with memory as well as computational constraints.

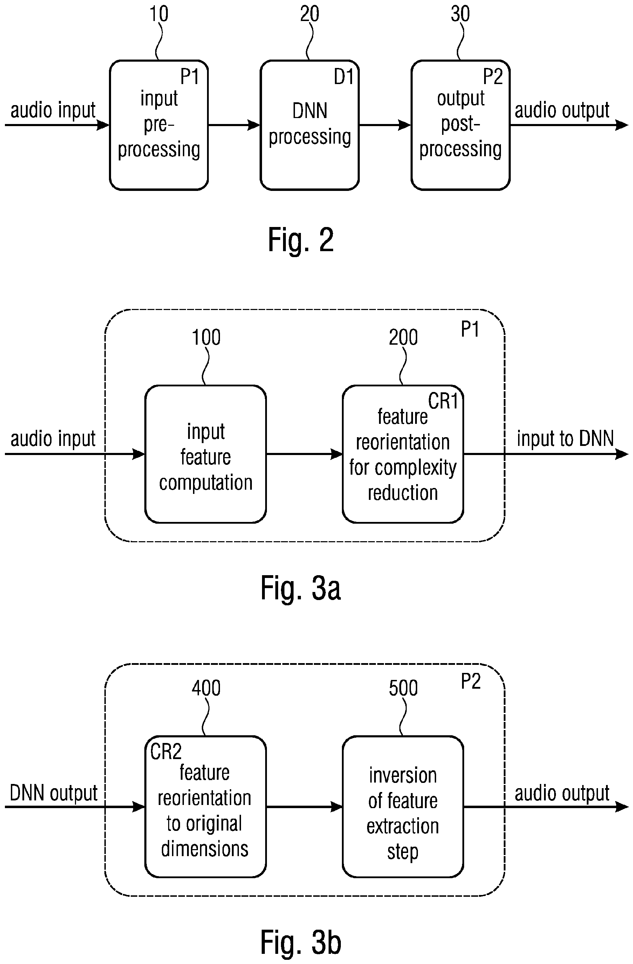

A typical processing pipeline for DNN based audio processing methods is shown in Fig. 2. The input for such methods is generally an audio waveform which is also referred to as the time-domain audio signal. The first block in this pipeline is the input pre-processing block (Block P1). This block mainly consists of processing methods to extract features from the audio waveform and perform some form of dimensional alignment to conform to the input dimension requirements of the DNN model. The feature extraction in this block can be either a deterministic time-frequency transform such as short-time Fourier transform (STFT) or be a set of features learnt via backpropagation for a specific application. Following the feature extraction step, a multi-dimensional (typically 2D or 3D) tensor is obtained which is then provided as an input to the main DNN processing block (block D1).

The block D1 is the main DNN processing block that operates on the provided input to perform the task for which it is designed. For example, in the case of mask-based noise reduction/speech enhancement [ref], D1 can be a DNN mask estimator that estimates a mask to obtain an enhanced version of the feature representation of the audio input that only consists of the feature representation of the speech component and eliminates the non-speech components.

The output of D1 is then provided as input to the output post-processor (block P2). The output post-processing block mainly consists of final processing operations to obtain the final feature representation of the output audio signal and the inverse operation of the transform/feature extraction applied in P1 to obtain the final audio output. For example, taking the same application scenario of noise reduction/speech enhancement as above, the block P2 would consist of the masking operation where the estimated mask from D1 is applied to the original feature representation of the input signal to obtain the enhanced feature representation to which the final inversion operation is applied to obtain the output audio waveform.

The input pre-processing block P1 is also indicated with reference number 10, the DNN processing block D1 is also indicated with reference number 20 and the output post-processing block P2 is indicated by reference number 30.

The learning procedure of a deep learning system can be negatively affected due to a very high dynamic range of the input features. For example, in DNN based audio processing systems, this effect can be seen in the form of loud and quiet sounds occurring together in an audio signal. In DNN based image processing systems, for example, this effect can be seen in the form of bright and dark image regions occurring together in the same picture.

In literature, several techniques/forms of input signal normalization have been applied to mitigate the issue. A specific input value compression method known as power law compression has also been used. In general, power law compression can be applied to any kind of input signals (e.g., audio signals, image signals, radar signals).

In the following, a general signal model is considered to represent arbitrary kinds of input signals, given by

$$\mathbf{s} = \mathbf{s}_{\mathrm{re}} + j\mathbf{s}_{\mathrm{im}} = \mathbf{s}_{\mathrm{abs}}e^{-j\mathbf{s}_{\mathrm{ph}}}$$

where $\mathbf{s}$ is a vector containing a number of K input signals, which can be expressed, e.g., in terms of real and imaginary signal components $\mathbf{s}_{\mathrm{re}}$ and $\mathbf{s}_{\mathrm{im}}$, respectively, or in terms of magnitude and phase components $\mathbf{s}_{\mathrm{abs}}$ and $\mathbf{s}_{\mathrm{ph}}$, respectively. For example, when representing an audio signal of one or multiple microphones in the time-frequency domain, $\mathbf{s}$ contains $K$ elements corresponding to the $K$ microphones, and the real and imaginary components (or magnitude and phase components) are the real and imaginary components (or magnitude and phase components) resulting from the time frequency transform (e.g., STFT) of the microphone signals. As a further example, when representing images, vector s may contain 3 elements per image pixel, representing, e.g., the RGB values. In this case, the imaginary components (or phase components) may be zero, unless the image is transformed with, e.g., a Fourier transform. With this signal model, the $k$-th element can be represented as

$$S_k = S_{k,\mathrm{re}} + jS_{k,\mathrm{im}} = S_{k,\mathrm{abs}}e^{-jS_{k,\mathrm{ph}}}$$

In existing works, power law compression is mainly applied, for example, only to the magnitude spectrogram of the computed frequency features, i.e.,

$$C_k = |S_k|^{\alpha} = \left|S_{k,\mathrm{re}} + jS_{k,\mathrm{im}}\right|^{\alpha} = S_{k,\mathrm{abs}}{}^{\alpha}$$

where $S_k$ is the $k$-th element of $\mathbf{s}$, $\alpha$ is the power law factor, and $C_k$ is the compressed signal corresponding to the $k$-th input signal. Usually, the compressed signal vector $\mathbf{c}$ with its elements $C_k$ is subsequently processed using a DNN, resulting in the compressed signal vector $\mathbf{d}$ with its elements $D_k$. Afterwards, just prior to the final feature inversion step, the power law compression is reversed to obtain the final output feature representation, given by vector **t**, i.e.,

$$T_k = |D_k|^{1/\alpha}$$

where $T_k$ is the $k$-th element of the final output feature vector **t**. Note that in the equations above, only the magnitude of the input (and output) signals is subject to compression (and expansion) and the power law factor is constant.

In this work, power law compression is used to compress/limit the dynamic range of each separate component of the input feature values and the aim is to improve the learning and generalization capability of the DNN, i.e., the power law compression is applied to the complete input feature representation instead of only a part of the input such as the magnitude component. Expressed mathematically, the compressed signal with the proposed power law compression can be expressed, e.g., as

$$C_k = C_{k,\text{re}} + jC_{k,\text{im}} = C_{k,\text{abs}}e^{-jC_{k,\text{ph}}}$$

where $C_{k,\text{re}}$ is the compressed real-part component, $C_{k,\text{im}}$ is the compressed imaginary-part component, $C_{k,\text{abs}}$ is the compressed magnitude component, and $C_{k,\text{ph}}$ is the compressed phase component, of the $k$-th input signal, respectively.

Generally, although neural network applications find more and more distribution in the field, the complexity of neural network processing procedures nevertheless plays a significant role not only in embedded systems and specific hardware systems, but also in other applications that do not run on embedded systems. The reason is that the neural network complexity maps in high processing resources requirements, a high electric power consumption and associated problems such as the provision of processor resources, cooling requirements for the electronic processors, and timing requirements particularly in the context of limited computational resources.

It is an objective of the present invention to provide an improved concept for processing information signals.

This objective is achieved by an apparatus for processing an information signal of claim 1, a method for processing an information signal of claim 15, or a computer program of claim 16, where preferred embodiments are claimed in the dependent claims.

In accordance with the first aspect of the present invention, an apparatus for processing an information signal such as an audio signal or an image signal or a radar signal comprises a feature extractor for extracting a set of features from the signal, the set of features having a first dimension. The apparatus additionally comprises a feature segmenter for segmenting the set of features into a first subset of features and a second subset of features, the first subset of features having a second dimension and the second subset of features having a third dimension, where the second and third dimensions are lower than the first dimension. Furthermore, the first and the second subsets of features have an overlapping range so that one or more features of the set of features are included in the first subset and in the second subset.

Additionally, the apparatus comprises a neural network processor configured for processing the first subset using a first neural network to obtain a first result and for processing the second subset of features using a second neural network to obtain a second result. The results are combined by a feature combiner for combining the first result and the second result using a third neural network, wherein the third neural network has a third complexity which is lower than a first complexity of the first neural network or which is lower than a second complexity of the second neural network, and the output of the feature combiner is a result set of features having a result dimension being greater than the second dimension or the third dimension and preferably equal to the first dimension. Furthermore, an output post-processor is provided for post-processing the result set of features to obtain a processed information signal.

In accordance with the first aspect of the present invention, processing blocks for low complexity deep neural network of (DNN) based audio processing methods are obtained. In preferred embodiments, focus is placed on the computational complexity in the primary instance, i.e., more focus is placed on the computational complexity than the memory complexity. Furthermore, the apparatus and methods and computer programs are, in a preferred embodiment, presented in the context of a neural network based noise reduction solution. However, the inventive procedures in accordance with the first aspect, but also in accordance with second and third aspects to be described later on are also applicable for other neural networks or deep neural network based solutions for problems in audio or other information signal processing that require reconstructed information signals at the output. Such applications may, for audio signal applications, comprises a de-reverberation processing, an echo cancellation processing, a speech or audio coding application, bandwidth extension applications, etc. For image signal processing, applications such as picture enhancement, edge sharpening enhancement, picture recognition or other image processing applications can be enhanced with the inventive procedures in accordance with the first, the second and/or the third aspect. Additionally, the analysis of radar signals for the purpose of detecting and locating and object also relies on the analysis of features at different frequency ranges of the signals, for example.

Generally, a complexity or a computational complexity of a neural network can be quantified in many different quantities such as floating point operations (FLOPS), wherein a higher number of floating point operations represents a higher complexity, or in execution time on one or more target hardware(s), wherein a higher execution time represents a higher complexity, or in power consumption of a certain device, wherein a higher power consumption represents a higher complexity, or a number or MAC (Multiply and Accumulate) operations, wherein a higher number of MAC operations represents a higher complexity.

In accordance with the second aspect of the invention, the way how the extracted features are presented to the signal processor exemplarily comprising one or more neural networks is in the focus. An apparatus for processing an information signal in accordance with the second aspect of the invention comprises the feature extractor for extracting a set of features from the information signal. The feature extractor comprises a raw feature calculator for calculating raw feature results, where each raw feature result has at least two raw feature components. Preferred raw feature components are the magnitude and the phase on the one hand or the real part and the imaginary part of a feature or feature result on the other hand. The feature extractor additionally comprises a raw feature compressor for performing an compression of a dynamic range to the at least two raw feature components to obtain at least two compressed raw feature components for each raw feature result. Hence, in an embodiment, the raw feature compressor not only compresses the magnitude of a raw feature result but also compresses the phase of the raw feature result. Alternatively, the raw feature compressor not only compresses the real part of a raw feature result but also compresses, in addition to the real part, the imaginary part of the raw feature result.

Both the at least two raw feature components for each raw feature result are provided to the signal processor for processing the set of features having two compressed components to obtain a processed information signal, wherein the information signal can be e.g., an audio signal, an image signal, or a radar signal.

In accordance with this second aspect, a preferred way of compression is a power law compression, which is used to compress/limit the dynamic range of each separate component of the input feature values, and the aim is to improve the efficiency and performance of the learning and generalization capability of a deep neural network. Therefore, in accordance with the second aspect, the preferred power law compression is applied to the complete input feature representation, i.e., all components of a plurality of components instead of only a part of the input such as the magnitude component only, i.e., only a subset of the plurality of components.

This full dynamic compression makes sure that each representation of the set of features can be processed, i.e., a real/imaginary representation can be processed where necessary, or a magnitude/phase representation can be processed as needed. Hence, both representations can be processed and, it has been shown that the performance of the neural network processor is better with respect to complexity and quality compared to a situation where only the magnitude is compressed but not the phase.

In accordance with the third aspect of the invention, a multi-stage processing is performed in the neural network processor. An apparatus for processing an information signal in accordance with the third aspect of the present invention comprises a feature extractor for extracting a set of features from the information signal, wherein each feature of the set of features comprises at least two feature components, where a first feature component of the at least two feature components is more important than a second feature component of the at least two feature components. Furthermore, the set of features comprises a first subset with the first feature components and a second subset with the second, less important feature components.

The apparatus additionally comprise an neural network processor comprising a first neural network for receiving, as an input, the first subset and for outputting a processed first subset. The neural network processor additionally comprises a combiner for combining the processed first subset and the second subset to obtain a combined subset. The combined subset is preferably input into a second neural network for receiving, as an input, this combined subset and for outputting a processed combined output. The processed combined output represents the processed information signal or the apparatus is configured to calculate the processed information signal using the processed combined output. In particular, a complexity of the first neural network that processes the first more important set of features is greater than the complexity of the second neural network that processes the second less important subset or set of feature components.

Hence, in accordance with the third aspect, that relates to a variety of applications related to deep neural network based signal processing, the input features are decomposed or divided into multiple components. Furthermore, all the components need not be equally important in the context of the target task. Therefore, a DNN based processing pipeline such as the neural network processor is decomposed into multi-stage processing, wherein each stage deals with the processing of the components with reducing importance in the context of the task at hand. In particular, each subsequent stage deals with new but less relevant or less important input information, so that neural networks or DNN modules in such a design can also be of declining computational complexity from stage to stage.

Preferably, all aspects can be combined into each other but all aspects can also be implemented separately from each other, or only two out of three aspect can be combined as the case will be.

In a combination of the first aspect and the second aspect, the power law compression is applied to the set of features that are input into the feature segmenter.

Hence, the set of features that are further processed by the feature segmenter and the subsequent elements of the apparatus for processing an audio signal in accordance with the first aspect is a set of features having feature components that are compressed with respect to their dynamic range not only with a single component but with two or more, i.e., multiple components, such as the magnitude and the phase or the real part and the imaginary part.

In such a situation, a feature decompression takes place either before or after the processing of the feature combiner in the processing direction so that, in the end, the output post processor post-processes the decompressed result set of features to obtain the processed information signal.

In such a combination of the first aspect and the second aspect, the third aspect can also be implemented either in the first neural network or the second neural network that process the first and the second subset of features.

Hence, a combination of all three aspects is performed where the features used by the feature segmenter are compressed features and at least one of the first neural network or the second neural network operates in a multi-stage low complexity mode where neural networks with declining complexity operate for processing features with declining importance from stage to stage.

However, the first aspect of the invention can also be applied using the multistage processing of the third aspect, but without using the power law compression for both components in accordance with the second aspect.

In other embodiments, the second aspect of the invention can be performed together with the third aspect or alone but without the first aspect relating to the feature segmentation with overlap and the corresponding feature combination with a low complexity neural network. In such a procedure, the set of features can nevertheless be split along the channel direction but without segmentation into overlapping segments. Nevertheless, the splitting along the channel direction can also take place with overlapping segments.

Furthermore, the third aspect with respect to multi-stage low complexity neural network processing can also be performed without feature segmentation or without splitting along the channel direction and even without power law compression as the case may be. However, the combination of the second aspect together with the first aspect is nevertheless preferred in case of processing applications with moderate sizes of sets of features. Such moderate sizes occur, for example, for audio applications with relatively low audio sampling rates resulting in relatively small sizes of feature sets. This is exemplarily the case when the feature extraction takes place using a time-frequency decomposition relying on a real-valued or preferably a complex-valued filterbank such as a QMF or an FFT-based filterbank that generates a time-frequency representation of the information signal such as the audio signal, or the radar signal. In image signals, the feature extraction can be a spatial filterbank or spatial Fourier transform that generates, for an image, a one or two-dimensional representation of cosine-like basis functions represented by an amplitude and a phase or a real part and an imaginary part.

Preferred embodiments of the present invention are subsequently disclosed with respect to the accompanying drawings, in which:

Fig. 1a    is an apparatus or a method for processing an information signal in accordance with the first aspect;

Fig. 1b    is an apparatus or a method for processing an information signal in accordance with the second aspect;

Fig. 1c    is an apparatus or a method for processing an information signal in accordance with the third aspect;

Fig. 2    is a schematic view of a typical deep neural network (DNN) based audio processing pipeline;

Fig. 3a    is an implementation of a feature extractor and a feature segmenter in accordance with the first aspect;

Fig. 3b    is an implementation of the feature combiner and the output post processor in accordance with the first aspect;

Fig. 4    is a preferred implementation of the feature segmenter and the subsequently performed channel-wise sub-band splitting in accordance with the preferred embodiment of the first aspect;

Fig. 5    is a preferred implementation of the neural network processor in accordance with the first aspect;

Fig. 6    is an illustration of the segmentation of the set of features into a first subset of features and a second subset of features;

Fig. 7    is an illustration of the second subset of features before and subsequent to the splitting into multiple segments placed along a channel dimension;

Fig. 8    is an implementation of the feature combiner comprising a stacker for performing a channel-wise stacking and a subsequently connected frequency sub-band merging;

Fig. 9       is an illustration of the result of the second neural network of Fig. 1a before and after the stacking of the segments;

Fig. 10      is an illustration of the first subset of features and the second subset of features subsequent to the channel-wise sub-band stacking to the left in Fig. 10 and the combination of the first result and the second result at the input into the third neural network to the right of Fig. 10;

Fig. 11      is a preferred implementation of the neural network processor in accordance with the third aspect;

Fig. 12      is another preferred implementation of the neural network processor in accordance with the third aspect;

Fig. 13      is a preferred implementation of the combiner of Figs. 1c, 11 or 12;

Fig. 14a     is a preferred implementation of the raw feature compressor of Fig. 1b in accordance with the second aspect;

Fig. 14b     is a preferred implementation of a portion of the signal processor of Fig. 1b in accordance with the second aspect;

Fig. 15a     is a preferred implementation of the present invention combining the first aspect and the second aspect;

Fig. 15b     is a table illustrating the complexity of the Fig. 15a embodiment and the Fig. 16 embodiment;

Fig. 16      is a preferred implementation of the invention in accordance with the second aspect or the second aspect and the third aspect;

Fig. 17      is another preferred implementation of the present invention in accordance with the second aspect or the second aspect and the third aspect; and

Fig. 18      is a table illustrating the complexity in MFLops for the Fig. 16 embodiment and two implementations of the Fig. 17 embodiment.

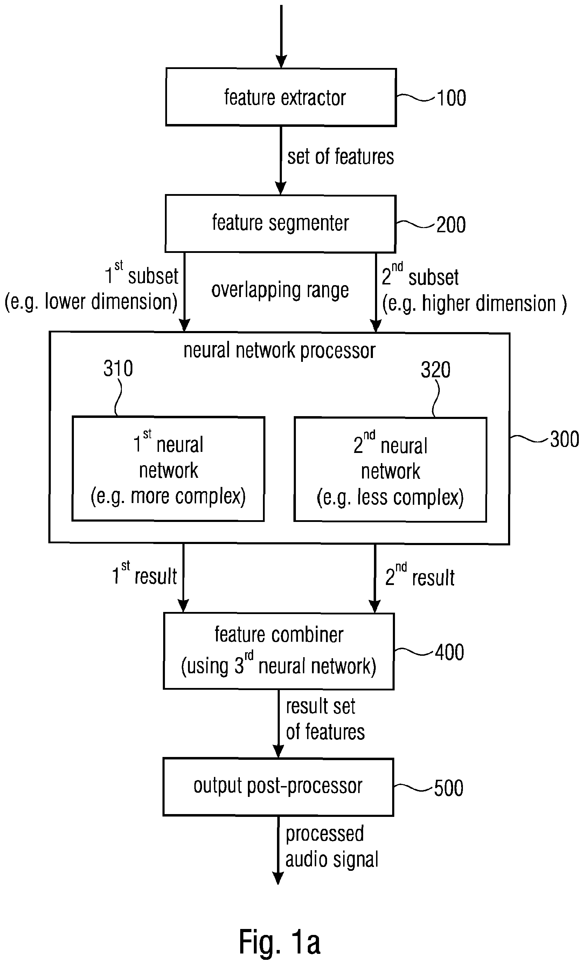

Fig. 1a illustrates an apparatus or method for processing an audio signal in accordance with the first aspect. The apparatus comprises a feature extractor 100 for extracting a set of features from the information signal such as an audio signal, the set of features having a first dimension. The set of features having the first dimension is input into a feature segmenter 200 for segmenting the set of features into a first subset of features and a second subset of features, wherein the first subset of features has a second dimension and the second subset of features has a third dimension, wherein the second and third dimensions are lower than the first dimension. Of course, a higher number of subsets such as three or four can be used as well. Furthermore, the first subset of features and the second subset of features have an overlapping range so that one or more features of the set of features are included in the first subset of features and in the second subset of features. The first subset and the second subset of features are input into a neural network processor 300. The neural network processor 300 is configured for processing the first subset of features using a first neural network 310 to obtain a first result, and for processing the second subset of features using a second neural network 320 to obtain the second result.

The first and the second networks can be two different or independent networks, or can be parts of one and the same overall neural network, where the parts can be disjunctive to each other or can both use one or more portions of the overall neural network, as long as one or more parts of the overall neural network can be identified that are only used by either the first neural network 310 or the second neural network 320.

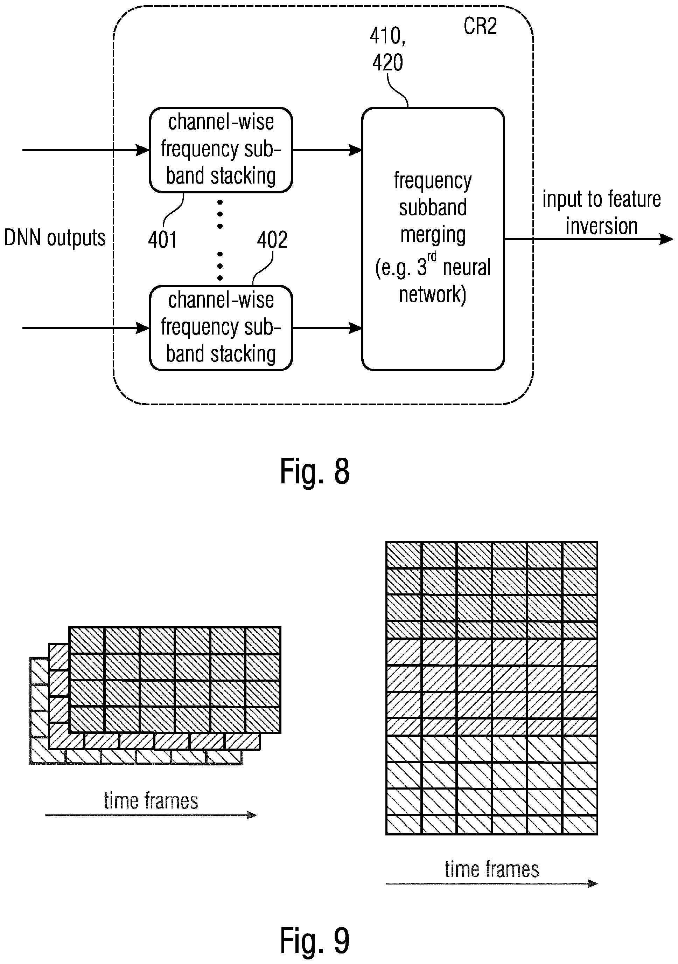

Both, the first and the second results are input into the feature combiner 400 for combining the first result and the second result using a third neural network 420 shown in Fig. 8. The third neural network has a complexity that is lower than a complexity of the first neural network or of the second neural network. The result of the processing by the feature combiner 400 is a result set of features that has a result dimension being greater than the second dimension or the third dimension and being preferably equal to the dimension of the set of features as obtained by the feature extractor 100. The result set of features is input into an output post-processor 500 for post-processing the result set of features to obtain a processed audio signal.

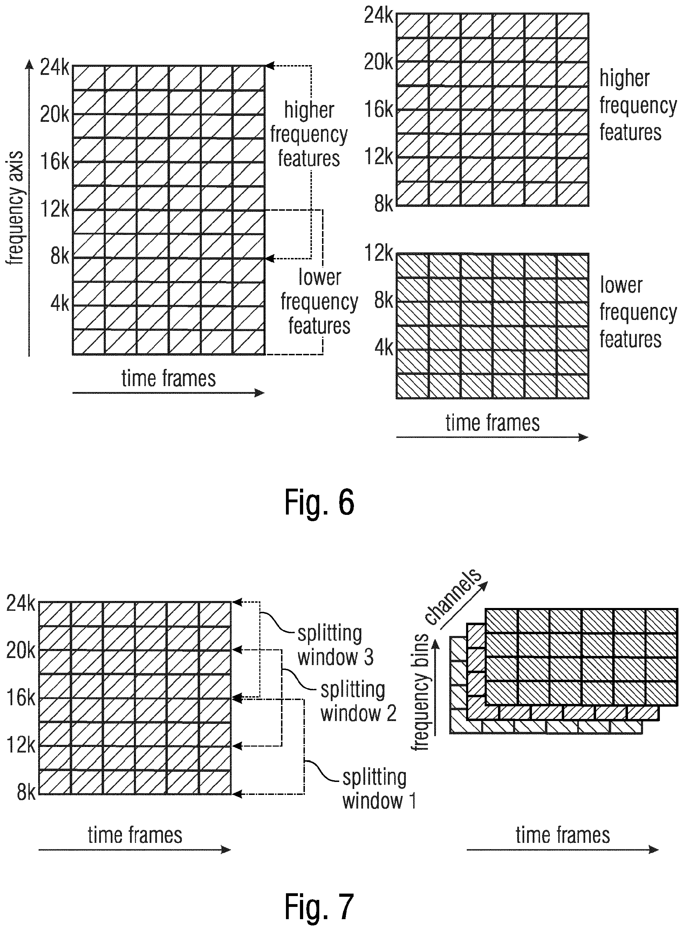

In a preferred implementation, the feature extractor 100 comprises a time-frequency decomposer for generating, from the audio signal or radar signal being in a time domain representation, a decomposed signal being in a time frequency representation comprising a sequence of time frames, wherein each time frame has a number of frequency bins. Furthermore, the feature extractor 100 comprises a feature set builder for building the set of features from the time-frequency representation. Fig. 6 illustrates, at the left hand side, an extract of a time-frequency representation with only six time frames and an exemplary number of only 12 frequency bins, although many more frequency bins may actually be used in the practice as will be discussed later. The Fig. 6 example already shows the situation subsequent to the operation of the feature said builder, since the sequence of six time frames has already been taken out from the larger time-frequency representation to obtain a set of features. By means of the operation of the feature segmenter, the first subset of features illustrated at the lower part of the right hand side of Fig. 6 and the second subset of features illustrated at the right upper part of Fig. 6 is obtained. It is shown in Fig. 6 that the overlapping range comprises two frequency bins between 8kHz and 12kHz, although it is emphasized that this is only an example. Actually, for the purpose of a sampling rate of 48kHz resulting in frequency features up to 24kHz, one time frame will comprise for example 769 frequency features.

In order to undo the feature extraction, the frequency-time composer is provided as a functionality of the output post-processor 500 of Fig. 1a which composes, from an input set of features being in the time-frequency representation, the processed information signal being in the time domain representation. In an embodiment, the input set of features is the result set of features or, alternatively, the input set of features input into the frequency-time composer or frequency-time transformer is derived from the result set of features and the set of features, i.e., the features being input into the feature extractor 100 of Fig. 1a.

When, for example, the present invention is applied for calculating the mask or time/frequency mask for the purpose of noise reduction or speech enhancement, the input set of features input into the frequency-time composer is not the mask itself, but is the result when the mask itself has been applied to the original time-frequency representation as generated by the feature extractor 100. The time frequency masks can be applied as spectral gains to the input signal input into the feature extractor 100 to achieve the result of noise reduction or speech enhancement. Alternatively, the time/frequency mask can also be used to estimate, for example, power spectral density matrices of a noise or speech signal and, then, one or more informed spatial filters can be calculated that are then applied to the input signal.

When, however, the processing is used, for example for the purpose of bandwidth extension, then the result of the neural network processing, i.e., the result set of features as obtained by the feature combiner can be the bandwidth extended audio signal in the bandwidth extension range or the full audio signal, i.e., the audio signal in the base band and the extended band, but still existing in a time-frequency representation, and the functionality of the output postprocessor 500 will simply be the frequency-time conversion of the bandwidth extended audio signal. When, however, the neural network processing is applied to derive bandwidth extension parameters from the input signal, the parameters are to be applied to the input signal to derive, in the end the bandwidth extended output signal.

Other applications in addition to noise reduction or speech enhancement or bandwidth extension can be applications for source separation, where the input signal, for example, is an input signal having its information from, for example, several different speakers placed at different positions, and the input signal comprises, for example, several microphone signals. In this situation, the result set of features once again can consist of frequency masks, which can either be binary, so that the value at the given time frequency bin is one at the given bin representing the time frequency mask of the dominant source, and zero for the time frequency masks of all other sources, or soft, so that the entry at a given bin of each time frequency mask represents a probability that the corresponding source is dominant at that bin. As stated, the time frequency masks can be applied as spectral gains to one of the microphone signals to achieve source separation. However, the time frequency mask can be used also as a means to estimate for example a power spectral density (PSD) matrices of the different source signals and, then, informed spatial filters are computed for the purpose of this blind source separation. Hence, depending on the certain implementation, the result set of features can be applied to the information signal and then the result is converted into the time domain, or the result set of features is already the processed signal in the frequency domain and the output post-processor only performs the processing to convert the frequency domain representation into the time domain representation.

Hence, for the purpose of the mask processing, the output post-processor 500 comprises a mask processor for applying the time-frequency mask as a spectral gain mask to the set of features in the time-frequency representation to obtain the input set of features, or for calculating a processing filter from the time-frequency mask and for applying the processing filter to the audio signal or the set of features to obtain the input set of features.

In a further implementation, the first neural network is more complex than the second neural network, and the first subset of features comprises information of the audio signal from a lower frequency range of the audio signal or the radar signal. Furthermore, the second subset of features comprises information of the audio or radar signal from a higher frequency range of the audio or radar signal. Hence, the portion of the audio or radar signal which is typically more important for the perception or processing intention, respectively, i.e., the lower frequency range is processed with a higher complex neural network and the portion that is less important for the speech perception, for example, of the audio signal, i.e., the higher frequency range of the audio signal is processed using the less complex second neural network 320 of Fig. 1a. For radar signals, this situation can be different, when certain objects to be identified or located map with certain frequency ranges in the radar signals. An example is that objects with certain speeds will have Doppler frequencies in certain frequency bands that can be processed with a higher complexity with respect to other frequency bands that map to velocities that are not in the main focus of a surveillance task.

In a preferred embodiment, the feature segmenter 200 is already configured to generate the first subset of features and the second subset of features so that the second dimension of the first subset of features is lower than the third dimension of the second subset of features. Thus, a lower dimension first subset is processed with the more complex first neural network 310 so that a large amount of the processing power is placed onto the specific portion of the information signal in order to obtain an as good as possible enhancement of the specific such as lower frequency portion under the situation of limited resources.

The feature segmentation illustrated in Fig. 6 can be further enhanced using a splitting of the second subset of features into second multiple segments. Furthermore, these second multiple segments obtained by a means of the for example three splitting windows 1, 2 and 3 in the left portion of Fig. 7 are placed along the channel dimension as illustrated in the right hand side of Fig. 7 so that the channel number of the input set to be input into the second neural network 320 is enhanced. However, at the same time, when the channel number is enhanced, the frequency or feature input dimension is reduced.

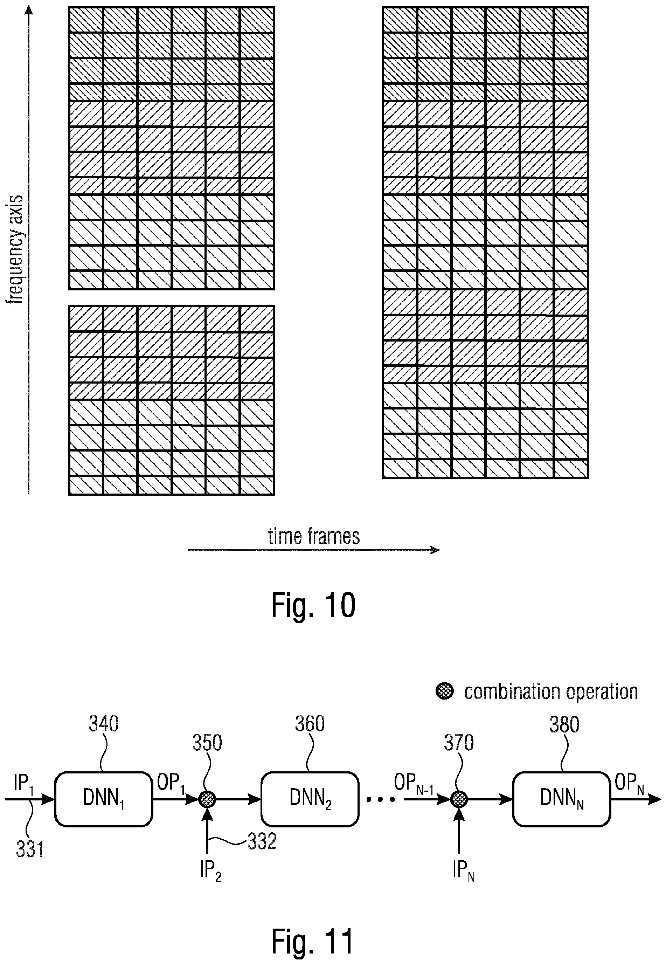

In a further embodiment, not only the second subset that, for example, covers the higher frequency portion of the audio signal, is split, but also the first subset of features is split into first multiple segments, and the first multiple segments are placed along a channel direction to also enhance the channel number of the input set to be input into the first neural network. As illustrated, for example, in the example shown in Fig. 10, the first subset has been split into two segments, and the second subset has been split into three segments. Hence, the number of the second multiple segments is three and the number of the first multiple segments is two. In other embodiments, and depending on the situation, it is also useful to only perform the channel-wise frequency sub-band splitting to the second subset of features, i.e., to the higher frequency range as illustrated in Fig. 7 and to not perform such a splitting to the first subset of features, i.e., for example for the lower frequency range of the audio signal. In such a situation, the lower portion of Fig. 10 would simply consist of a single green color. Preferably, and as illustrated in Fig. 7, the splitting windows for splitting the subset of features into corresponding first or second multiple segments is overlapping and, particularly, overlapping by 50%, although a smaller overlapping width can also be used. The same is true for the overlapping applied by means of the frequency sub-band segmentation 200 illustrated in Fig. 6, where an overlap range is only one third of the size of the whole subset.

Particularly, Fig. 6 illustrates the preferred implementation, where the first set of features ranges from about 0 to about 12 kHz, i.e., covers about 12 kHz of frequency bins, while the second subset of features, i.e., the subset of features covering the higher frequency portion ranges from 8 kHz to 24 kHz covering 16 kHz of frequency bins.

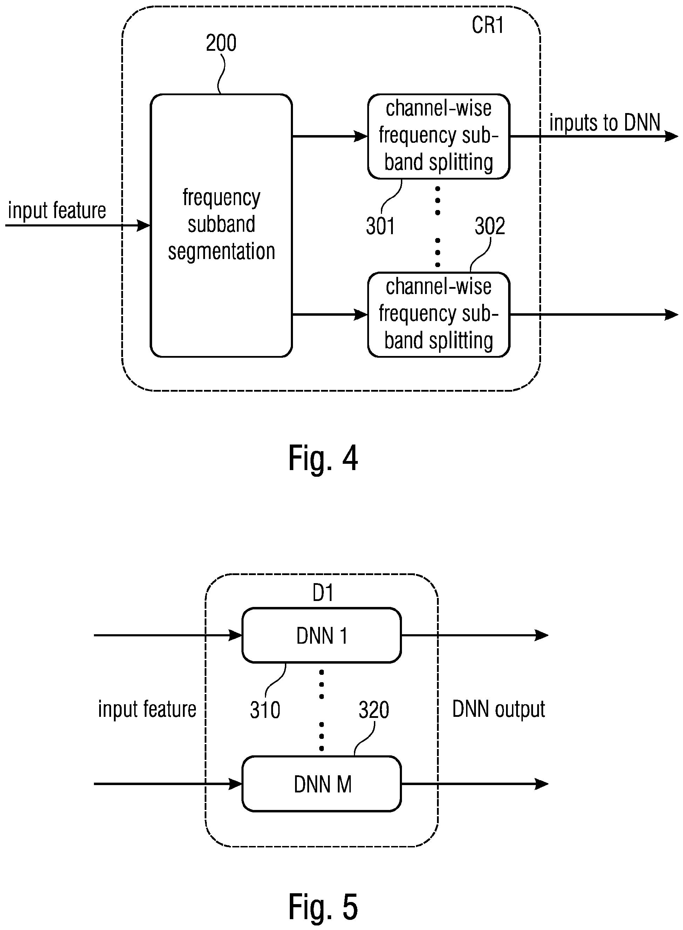

The corresponding output-side processing belonging to the channel-wise frequency sub-band splitting 301 or 302 as illustrated in Fig. 4 is the channel-wise frequency sub-band stacking 401, 402 illustrated in Fig. 8. Furthermore, when both the channel-wise frequency sub-band splitting and the frequency sub-band segmentation 200 is applied, then both features are undone on the output-side and, for this purpose, the invention in accordance with the first aspect uses the third neural network having a complexity being lower than the first complexity of the first neural network or the second complexity of the second neural network and, preferably, the third neural network is even less complex than both the first neural network 310 of Fig. 5 and the second neural network 320 of Fig. 5.

In accordance with the first aspect, this merging is performed by simply stacking the first result and the second result and, if necessary, by simply stacking the individual channels of the results so that a stacked set of features is obtained. Due to the overlap range for the frequency sub-band segmentation and due to the preferred overlap range of the channel-wise frequency sub-band splitting, the dimension at the input into the third neural network will be significantly higher than the dimension of the set of features, i.e., the first dimension at the output of the feature extractor 100. Nevertheless, due to the fact that the third neural network only has to undo the dimension increase and, with respect to the set of features, only has to significantly process the set of features for an overlapping frequency range while, typically, the features in a non-overlapping frequency range will not be necessary to be strongly processed by the third neural network, this network can be of low complexity even in view of an increased input feature dimension. Therefore, it is preferred that not only the complexity of the third neural network is lower than the complexity of the first neural network and the second neural network. Instead, the number of layers of the third neural network is smaller than the number of layers of the first neural network and the second neural network and, particularly it is preferred that the number of layers of the third neural network is, at the maximum, 1/3 or more preferable only 1/4 and even most preferable only 1/10 of the number of layers of the first neural network or the second neural network.

The preferred idea in this aspect is to introduce a feature reorientation block (CR1 in Fig. 3a **Fehler! Verweisquelle konnte nicht gefunden werden**.) in P1 after the feature computation step, which leads to the use of efficient hyper-parameter settings of the DNN model block to reduce the computation complexity.

Following the processing of the input by the DNN processing block (D1), the feature reorientation step is reversed to restore the output of the of the DNN to the original dimensions of the input features (CR2 in Fig. 3b) and finally the feature extraction step is inverted to obtain the output audio waveform.

As described before and shown in Fig. 2, the pre-processing block P1 consists of a feature extraction/computation step, where the audio input signal is transformed into a representation that can be, e.g., a 2D or 3D real-valued tensor. For example, when the applied feature extraction step is STFT, then the feature representation is a 2D complex valued tensor which can be represented as a 3D real-valued tensor of size $N \times K \times 2$, where N correspond to the number of frames, K corresponds to the number of frequency bins and 2 corresponds to for example the real-imaginary components or the magnitude-phase components. In case of the applied feature extraction step being a learned filterbank/feature, the feature representation is generally a 2D real-valued tensor of size N x K, where in this case K corresponds to the size of the feature dimension while N would correspond to the number of time frames.

To learn from the local structure of the feature representation, convolutional layers with small convolution kernels are typically applied in the initial stages of a DNN model for audio processing. Due to the use of multiple such layers the computation complexity of the model is mainly affected by the spatial dimensions of the input features, N and K. Alternatively, other types of layers such as fully connected or recurrent layers might also be used in the initial stages of the DNN model and in this case also the main factors affecting the complexity would be N and K.

The number of time frames N is determined by the window/frame length considered for the transform/filterbank/feature extraction applied to the signal as well as the length of the input audio signal. In real-time audio applications, which is the focus here, very small segments of audio, typically smaller than 50 ms are processed at a time which leads to the N being small for every processing instance. Therefore, the focus in this invention is mainly over the frequency/feature dimension of the input features.

The size of the feature/frequency dimension K is determined by the desired frequency/feature resolution as well as the sampling rate of the audio signal. For speech or audio processing tasks, the feature/frequency dimension can be, e.g., selected as a power of 2 and larger than 128. For higher sampling rates such as 32 or 48 kHz, the size of the feature dimension is typically very high, e.g., 512, 1024 etc. To reduce the computational complexity of the main DNN model when the size of the feature/frequency dimension is very high, the invention presents a combination of two feature reorientation techniques for complexity reduction as shown in Fig. 4. In the following, the techniques are described considering the use of a deterministic transform/filterbank, such as STFT, as the feature extraction step. The following descriptions explain the methods considering the feature dimension to be the frequency dimension specifically, however, the methods are also applicable in the case of use of any arbitrary feature representation.

Sub-band Segmentation

The first technique corresponds to a frequency sub-band segmentation method where the input feature is split along the frequency dimension K into multiple overlapping segments, $[s_1, s_2,..., s_M]$. In some academic works, a basic non-overlapping splitting idea has been presented to improve performance of DNN based speech enhancement methods specifically [1, 2]. In this report, the segmentation approach is presented as a method for reducing complexity and it is extended to be an overlapping split.

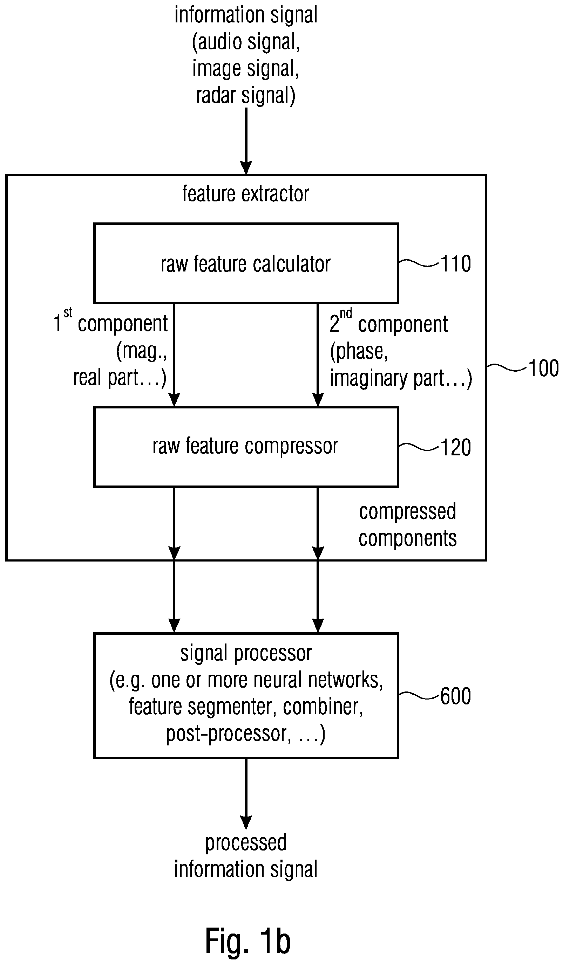

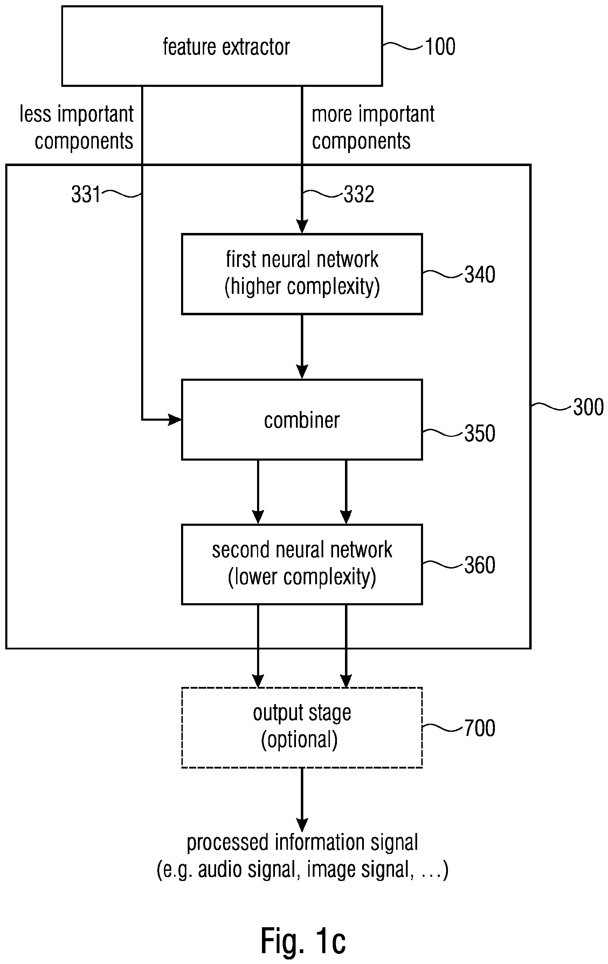

Following the split of the original input feature into segments, each feature segment is prepared as an input to an individual DNN model for processing of each of the segments separately. Therefore in this case, instead of a single DNN model, the block D1 in Fig. 1now consists of multiple DNN models (as shown in Fig. 5) that operate separately on the different frequency sub-band segments created by the sub-band segmentation technique.

An example of the segmentation technique and the creation of the corresponding input segments for the individual DNNs is shown in Fig. 6. In the provided example, an audio signal with a sampling frequency of 48 kHz was used. Computing the STFT features provides a feature representation where the frequency dimension represents signal content up to the Nyquist frequency of 24 kHz. With the presented splitting method, the frequency dimension in this case is segmented into two parts- a feature representation for the lower frequency range of 0-12 kHz and another for the higher frequency range of 8-24 kHz. Then, in this example, these two segments form the input to two different DNN models in the block D1.

- The sub-band segmentation can be chosen arbitrarily. Depending on the frequency dimension size desired for the individual DNN inputs and the number of individual DNNs to be employed, the number of segments M, and the size of the frequency dimension for each segment can be chosen.

- The size of the frequency dimension need not be same for the different segments. Depending on the audio processing task, the size for individual segments can be determined. E.g., for speech processing tasks, the size of the first segment can be determined based on the typical frequency range of speech activity when STFT is used as the feature representation. The size of the rest of the segments can be determined based on the number of DNNs that can be employed. Alternatively, the segmentation of the bands can be done using equivalent rectangular bandwidth (ERB), Mel scale or similar perceptual scales depending on the task for which the method is being developed.

- Overlap between the segments avoids processing artifacts in the boundary regions of the segmented feature representations when the processed outputs are merged to obtain the final audio output.

• Segmentation of the input along the frequency dimension facilitates in using less computationally complex individual DNNs compared to a large single DNN model. In a single model, due to the large input space, the number of computations per layer, especially in the initial layers, are quite high which leads to a high overall computational complexity of the system. By segmenting the input along the frequency dimension, the computational complexity in the initial layers can be controlled to be low enough to keep the overall complexity of the system low. The flexibility in determining the segmentation allows for designing an overall system where the combined complexity of the individual DNNs is lower than that of a single DNN model.

• On hardware platforms that allow for parallel processing, the processing with the individual DNNs can be done in parallel to further reduce the computational time of the overall system.

Channel-wise sub-band splitting

For this method, it is assumed that the initial layers of the individual DNN models (Fig. 5) consist of convolution layers that use small convolutional kernels to learn from local structure of the feature representation of the audio input. This is generally true for most DNN models for audio processing where the exploitation of/learning from the local structure of the audio input feature representation is important for improved performance over a large variety of tasks.

In this method, the individual input segments obtained after the Sub-band Segmentation block are further split into multiple overlapping segments of equivalent spatial dimensions and placed along the channel dimension. The idea of channel-wise splitting has been proposed earlier in [3, 4] as a more efficient feature extraction step compared to applying convolution over the whole input space. In the case of this invention, the idea is to use it in conjunction with the sub-band segmentation method as the second stage of complexity reduction. As mentioned earlier, the sub-band segmentation allows for keeping the computational complexity low in the early convolution layers due to the reduced input space (NxK → Nx$K_1$, Nx$K_2$, ..., where $K_1$, $K_2$, ... < K). Channel-wise splitting further extends this benefit by further reducing the spatial dimensions (N×$K_1$, N×$K_2$, ... ) of the input space of each of the individual inputs.

As an example, let us consider the segmented blocks on the right in Fig. 6. Then, the segmented block corresponding to the higher frequency features, can be further split into three uniform overlapping segments and each split segment is then arranged along the channel dimension to obtain the final input feature representation for the individual DNN.

- The overlap factor for the splitting can be arbitrarily chosen, under the constraint that the spatial dimensions (number of time frames and size of frequency sub-band dimension) of the individual splits need to be the same. This is required such that they can be arranged along the channel dimension. In typical convolution layer operation, small filters are applied to each channel separately followed by a weighted combination of the filtered values across the channel dimension to generate the output. Due to this, the channel-wise splitting aids in combining cross frequency sub-band information in the initial layer of the DNN while having lower spatial dimensions of the input for the small filters to traverse through and reduce the computational complexity in these initial layers.

- The overlap factor can be determined based on the desired reduction in spatial dimensions of the input and the number of channels. For example, in Fig. 7, to reduce the number of channels in the input to the DNN, the input can be split into three segments of equal spatial dimensions to reduce the computational complexity in the first convolutional layer.

Merging methods

Following the processing of the inputs by the individual DNNs, at the output of the each DNN in D1, an enhanced/modified version of the input feature representation is obtained.

The next task would be to recombine/merge the individual outputs to obtain the output feature(s) in the original dimensions such that it can be provided as an input to the feature inversion step (inverse STFT in this case) to obtain the output audio signal.

In most previous works that employ either subband segmentation [1,2] or channel-wise sub-band splitting [3,4,5], the merging method is generally an approach where the different sub-band outputs are concatenated along the frequency axis to obtain the final output. This is generally possible since the methods do not account for overlapping segmentation strategies. In one work [5], a learnable approach was preferred, where the concatenated output was passed through a separate speech enhancement model for a two-stage enhancement approach. In this case, the second enhancement model was equally complex as the first one.

In this invention, a simple concatenation along the frequency dimension is used followed by a small neural network to learn the optimal combination/merging of the cross-frequency information as well as account for the overlap between segments.

The two merging blocks within the overall merging method are shown in Fig. 8.

Channel-wise sub-band merging

- The obtained outputs of the individual DNNs are not constrained to be of any specific dimensions. The spatial and channel dimensions of these outputs can be arbitrary and different for each of the DNNs.
- Each of the output channels are stacked along the feature/frequency dimensions, to obtain the input to the next merging block. Please note that the overlap considered during the split is not replicated in the stacking step.
- If one considers the split segments from Fig. 7, then the merging step is as shown in Fig. 9. Please note that the frequency dimension of the merged output is always larger than or equal to the frequency dimension of the original input (Fig. 7) as any overlap between the split segments is not accounted for when merging.

Frequency sub-band merging

For the frequency sub-band merging step, the individual outputs after the previous merging step are stacked together similar to how it is described for the channel-wise sub-band merging step.

Fig. 10 shows this merging step for the two sub-band outputs that were obtained.

Following this first step, a small neural network is used as the final merging step to obtain the output feature representation in a desired dimension such as the original dimension of the input to the system or in a desired dimension being different from the original dimension of the input to the system, such as a smaller dimension than the original dimension.

- The neural network employed is not constrained to have any specific architectural blocks. It can range from being a multi-layer perceptron (MLP) network with few fully connected layers to a neural network which is a combination of convolutional, recurrent, and fully connected layers.

- The only constraint for the neural network design is that the last layer of the neural network should rearrange the frequency dimension of the output to be equal to the frequency dimension of the original input to the audio processing system. This is necessary for the inverse transform step. Alternatively, the last layer rearranges the frequency dimension of the output to be equal to a desired dimension being different such as smaller than the frequency dimension of the original input to the audio processing system. This can be the case, when a classifier is there.

Embodiments

1. In the first embodiment, all the processing modules described as a part of this invention can be, e.g., applied to design a low complexity DNN based audio processing system.

2. In the second embodiment, all the processing modules except for the sub-band segmentation can be used to design a low complexity DNN based audio processing system. The sub-band segmentation can be ignored in the cases when the feature dimension is not very large, e.g., when the feature dimension is lower than 512.

3. Further embodiments can include all other possible combinations of the different processing modules described here.

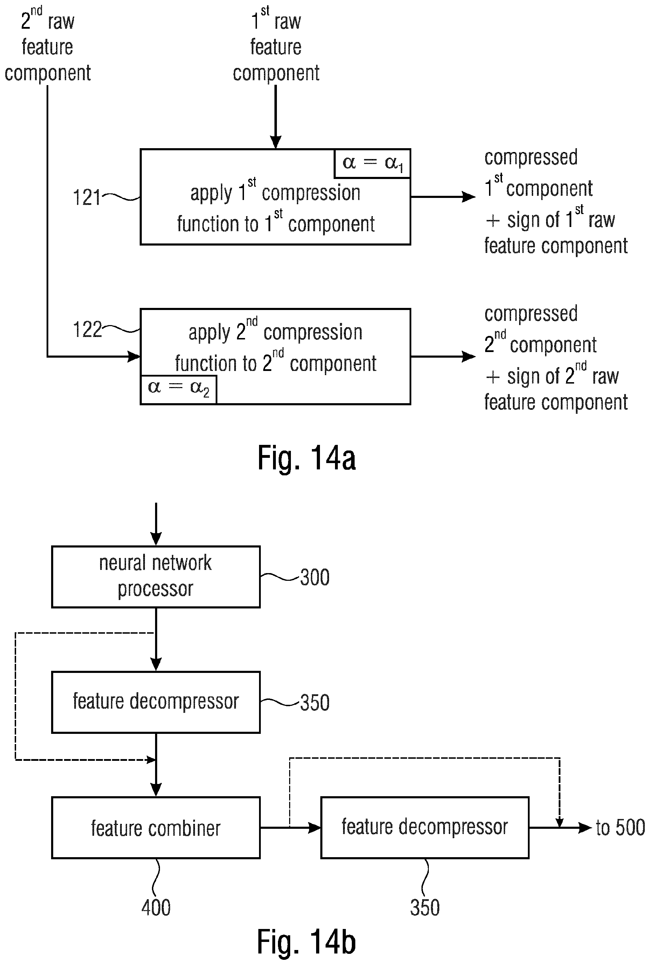

Subsequently, a preferred embodiment of the second aspect relating to the generation of compressed components for example, using a power law compression is discussed with respect to Fig. 1b and Figs. 14a, 14b.

An apparatus for processing an information signal which can be an audio signal, but which can also be an image signal, or a radar signal, for example, comprises the feature extractor 100 basically as illustrated before with respect to Figs. 1a to 10. Particularly, the feature extractor 100 is configured for extracting a set of features from the information signal, and the feature extractor comprises a raw feature calculator 120 for calculating raw feature results, where each raw feature result has at least two raw feature components as illustrated in Fig. 1b below block 110. One raw feature component of a raw feature result can be a magnitude and the other raw feature component of the raw feature result can be the phase of a complex amplitude of a cosine-like function, for example. Alternatively, the first component can be the real part and the second component can be the imaginary part of the corresponding raw feature result.

The two components, i.e., the magnitude and the phase or the real part and the imaginary part, for example, are input into a raw feature compressor 120 for performing a compression of the at least two raw feature components to obtain at least two compressed raw feature components for each raw feature result as illustrated by the two arrows below block 120 in Fig. 1b. Particularly, the set of features output by the feature extractor, therefore, comprises the compressed raw feature components for each raw feature result.

These raw feature components in compressed form are then input into a signal processor 600 for processing the set of features comprising the compressed raw feature component for each raw feature result to obtain a processed information signal. The signal processor 600 can comprise one or more neural networks as discussed before with respect to the first aspect such as in Fig. 1a or Fig. 5 or can comprise a single neural network 20 as illustrated in Fig. 2 or can comprise cascaded neural networks as illustrated with respect to the third aspect shown in Fig. 1c or Fig. 11 to Fig. 13. The signal processor additionally can comprise a feature segmenter, a feature combiner and/or a post processor as has, for example, been illustrated with respect to Fig. 1a and the related description.

On the other hand, the feature extractor 100 in Fig. 1a and the feature extractor as illustrated in Fig. 3a can also be implemented as shown in Fig. 1b, i.e., as discussed with respect to the second aspect.

The raw feature calculator 110 is preferably configured to calculate the complex value as the raw feature result, the raw feature result being a real part and an imaginary part or the magnitude and the phase as the at least two raw feature components, and the raw feature compressor is configured to perform a compression of the real part and the imaginary part or the magnitude and the phase to obtain the compressed raw feature components.

The raw feature compressor 120 is additionally configured to apply 121 a first compression function to a first raw feature component and to apply 122 a second compression function to a second raw feature component, wherein the second compression function can be different from the first compression function. Preferably, the raw feature compressor is configured to apply a power law compression using a power value of $1/\alpha$, wherein $\alpha$ is a fixed value or is a specific value learned for a specific application and, particularly, $\alpha$ consists of a real or integer number being greater than 1. Alternatively, the power value is $\alpha$. Then, the power value $\alpha$ is a fixed value or is a specific value learned for a specific application and, particularly, $\alpha$ consists of a real or integer number being lower than 1.

Preferably, the number $\alpha$ is different for each raw feature component and is particularly greater for raw feature components that are expected to have a higher number range such as for magnitude and phase. Preferably, the compression function is stronger with respect to its compression action for the magnitude compared to the phase but, when it can be expected that the real part and the imaginary part will have similar value ranges, similar compression function strengths and, therefore, similar $\alpha$ numbers for the parallel compressions can be applied.

Preferably, the raw feature calculator 110 is configured to calculate the raw feature components as absolute numbers and associated signs, and the raw feature compressor 112 is configured to apply the corresponding compression function to the absolute value and to retain the sign of a corresponding raw feature component.

Preferably, the information signal is an audio signal, and the raw feature calculator 110 comprises a time-frequency decomposer for decomposing the audio signal into a complex time-frequency representation. Alternatively, the information signal is an image signal, and the raw feature calculator 110 comprises a spatial transformer for decomposing the image signal into a complex spatial frequency representation.

Preferably, the signal processor 600 in Fig. 1b comprises a neural network processor 300 as illustrated in Fig. 1a or 5 or Fig. 2 at reference number 20 to obtain a processed set of features. Furthermore, as illustrated in Fig. 14b, a feature decompressor 350 for performing a decompression matching with the compression performed by the raw feature compressor 120 is provided to obtain a result set of features. Additionally, a post processor 500 is configured for post processing the result set of features to obtain the processed information signal.

Particularly, depending on the implementation and, particularly, depending on whether the feature segmentation 200 and feature combination 400 of Fig. 1a is applied, it is preferred that the feature decompression 350 takes place subsequent to the feature combination 400, i.e., that the third neural network with a low complexity operates on the compressed features as obtained by the neural network processor 300. However, in other embodiments, the feature combination can also take place in the non-compressed domain or in the real-imaginary part domain as described so that the feature decomposed 350 is placed between the neural network processor 300 and the feature combiner 400. To show the different alternatives, the first feature decomposer 350 is shown as optional by means of the pointed line and the same is true for the feature decompressor 350 that can also be passed by the pointed line.

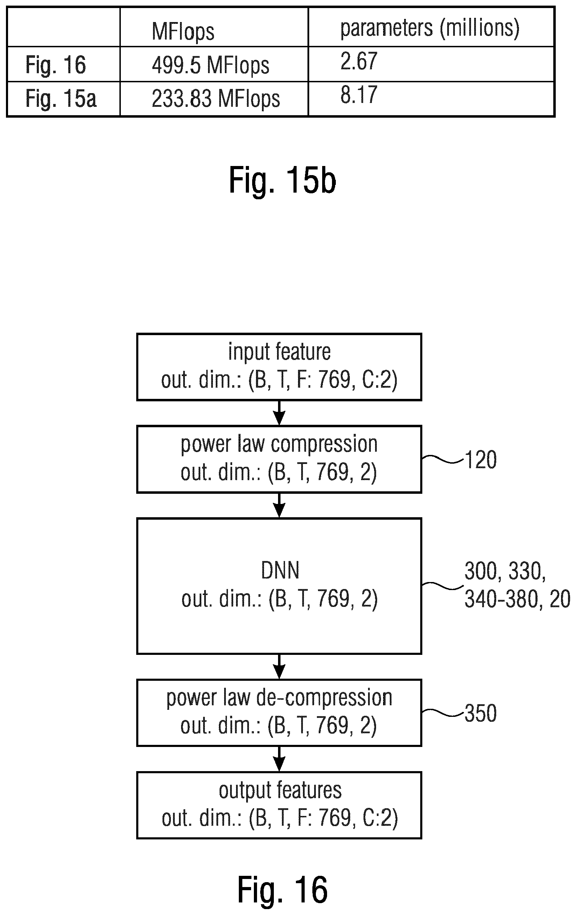

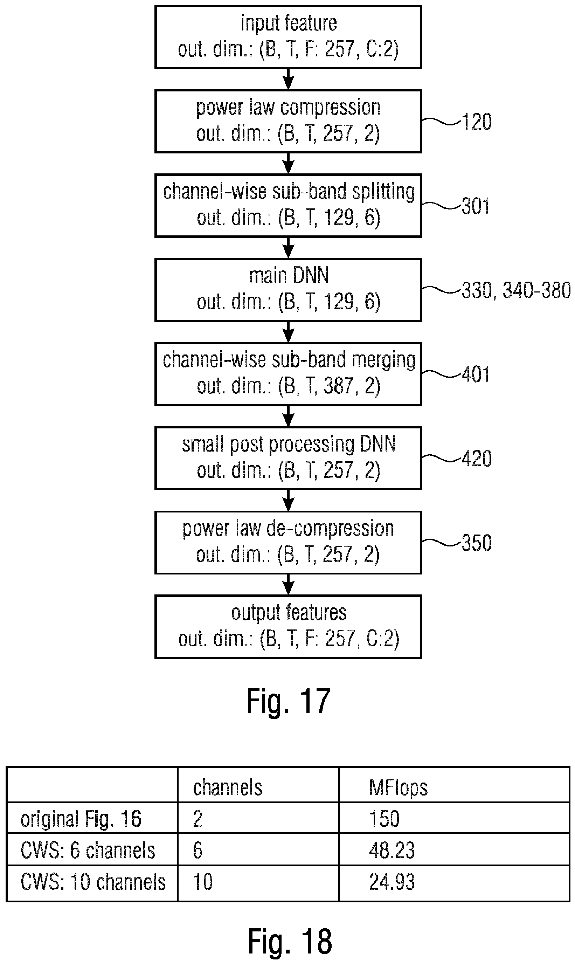

In another preferred embodiment, which is illustrated and described later on with respect to Fig. 16 and Fig. 17, the functionality of the raw feature compression 120 and the subsequent power law decompression 350 is combined with a processing using a single DNN 20 such as illustrated in Fig. 2. Additionally, in Fig. 17, the power law compression feature illustrated in accordance with the second aspect of Fig. 1b is also combined with the functionality of the channel-wise subband splitting 301 and the channel-wise subband merging or stacking 401 as discussed before with respect to Fig. 4 and Fig. 8, but without the functionality of the first aspect, i.e., the subband segmentation 200 and the frequency subband merging in a small post processing neural network 420.

Furthermore, the functionality of relying on a single neural network rather than two parallel neural networks as illustrated in Fig. 5, Fig. 1a or Fig. 15a is preferred for audio signals having sampling rates being lower than 24 kHz and where the dimension of the set of features in the frequency dimension is lower than 500 and greater than 200, and a channel number is 2. In such a situation, it is preferred to use a single neural network such as the neural network 20 of Fig. 2 or to use the cascaded neural network as discussed in connection with the third aspect of Fig. 1c or in the context of Figs. 11 to 13.

Furthermore, not only for this aspect, but also for the other aspects, it is preferred to use a number of segments for the channel-wise splitting between 2 to 4 so that the number of channels is between 4 and 8, and overlap of the segments for the channel-wise splitting is between 30 and 90 frequency bins and preferably between 60 and 70 frequency bins.

In this specification, power law compression is used to compress/limit the dynamic range of each separate component of the input feature values and the aim is to improve the learning and generalization capability of the DNN, i.e., the power law compression is applied to the complete input feature representation instead of only a part of the input such as the magnitude component. Expressed mathematically, the compressed signal with the proposed power law compression can be expressed, e.g., as

$$C_k = C_{k,\text{re}} + jC_{k,\text{im}} = C_{k,\text{abs}}e^{-jC_{k,\text{ph}}}$$

where $C_{k,\text{re}}$ is the compressed real-part component, $C_{k,\text{im}}$ is the compressed imaginary-part component, $C_{k,\text{abs}}$ is the compressed magnitude component, and $C_{k,\text{ph}}$ is the compressed phase component, of the $k$-th input signal, respectively.

In general, different compression functions can be used for every component and $k$-th input channel. The compression for a specific component and channel k can be expressed for example as

$$C_{k,(\cdot)} = f_{k,(\cdot)}\left(S_{k,(\cdot)}\right)$$

where $f$ denotes an arbitrary compression function and the subscript $(\cdot)$ indicates he different signal components, e.g., the real component re or imaginary component im. After processing the DNN, the power law compression can be reversed to obtain the components of the final output feature representation, i.e.,

$$T_{k,(\cdot)} = f_{k,(\cdot)}^{-1}\left(D_{k,(\cdot)}\right)$$

where $f^{-1}$ represents the inverse power law function (expansion function). The final output feature representation of the $k$-th channel can then be obtained from the individual components, e.g.,

$$T_k = T_{k,\text{re}} + jT_{k,\text{im}} = T_{k,\text{abs}}e^{-jT_{k,\text{ph}}}$$

where $T_k$ is the $k$-th element of vector t.

As an exemplary implementation of the compression steps above, one may consider the real and imaginary signal representation. In this case, the compressed components may be obtained as

$$C_{k,\text{re}} = (\pm)|S_{k,\text{re}}|^{\alpha_{k,\text{re}}}$$

$$C_{k,\text{im}} = (\pm)|S_{k,\text{im}}|^{\alpha_{k,\text{im}}}$$

where (+) denotes the original sign of the feature value $S_{k,(\cdot)}$. As can be seen, in this example, the power law

function $f_{k,(\cdot)}$ corresponds to taking the absolute value of the specific signal component while retaining the information of the sign. Moreover, the power law compression is applied to the complete signal representation, i.e., to both the real-part and imaginary-part component. After processing with the DNN, the power law compression can be reversed accordingly to obtain the components of the final output feature representation, i.e.,

$$T_{k,(\cdot)} = (\pm)|D_{k,(\cdot)}|^{1/\alpha_{k,(\cdot)}}$$

As another exemplary implementation, the magnitude and phase representation can also be considered. In this case, the compressed signal components can be obtained as

$$C_{k,\text{abs}} = \left(S_{k,\text{abs}}\right)^{\alpha_{k,\text{abs}}}$$

$$C_{k,\text{ph}} = S_{k,\text{ph}} \cdot \alpha_{k,\text{ph}}$$

In this case, though, similar to the previous example, the power law compression function is applied to the complete signal representation, the function $f_{k,(\cdot)}$ is different for the two components in this case. After the processing with the DNN, the power law compression is reversed accordingly, i.e.,

$$T_{k,\text{abs}} = \left(D_{k,\text{abs}}\right)^{1/\alpha_{k,\text{abs}}}$$

$$T_{k,\text{ph}} = D_{k,\text{ph}}/\alpha_{k,\text{ph}}$$

to obtain the final output feature representation.
In the proposed power law compression,

• The power law function $f$ (or, e.g., the power law factor $\alpha$) can be

   ∘ different for each component (e.g., re, im, abs, ph) and element k of the input feature representation.
   ∘ $\alpha$ can either fixed or learnt for a specific signal processing task via training.

Subsequently, reference is made to Fig. 1c in order to illustrate the third aspect of the invention related to multi-stage low complexity DNN processing. An apparatus or method for processing an information signal is illustrated in Fig. 1c, and the apparatus comprises a feature extractor 100 for extracting a set of features for the information signal. Each feature of the set of features comprises at least two feature components, where a first feature component of the at least two feature components is more important than a second feature component of the at least two feature components, and wherein the set of features comprises a first subset with the first feature components and a second subset with the second feature components.

Exemplarily, the more important components are the magnitudes of the spectral values obtained by a time frequency decomposition of the information signal being, for example, an audio signal, an image signal, a radar signal, or any other information signal that can be subjected to a feature extraction resulting in more important and less important components for an individual feature.

The apparatus additionally comprises a neural network processor 300 having a first neural network 340 for receiving, as an input, the first subset 332 and for outputting a processed first subset. Furthermore, the neural network processor comprises a combiner 350 for combining the processed first subset and the second subset 331 to obtain a combined subset. Additionally, the combined subset now having, for each feature, the processed first component and the second component is input into a second neural network 360 that outputs a processed combined output that is input into an optional output stage 700. Particularly, the combined output represents the processed information signal or the apparatus is configured to calculate, using the output stage 700, the processed information signal using the combined output.

Furthermore, the complexity of the first neural network 340 is greater than the complexity of the second neural network 360. Thus, the more important components are input into the more complex neural network 340 and the less important components 331 are input, subsequent to the combination, into the second lower complexity neural network.

Furthermore, with respect to image processing, the foreground portion of the image will represent the more important components and the background of the image will provide the less important components. Then, the feature extractor will process the features so that, for a certain image range, for example, a more important component and a less important component is calculated.

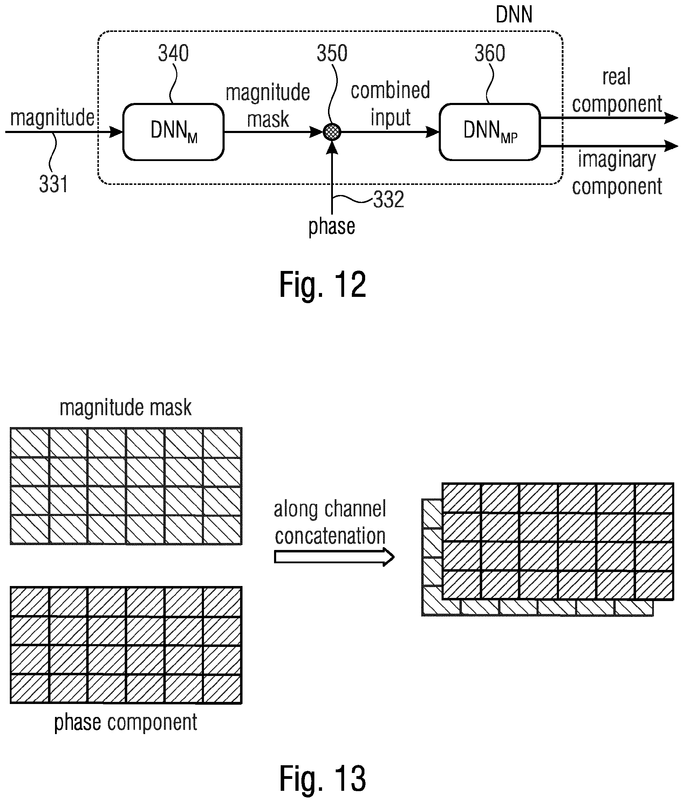

In a preferred embodiment, and this is also illustrated in Fig. 13, the combiner 350 concatenates the processed first subset and the second subset along the channel direction so that, for example, the processed first set representing a magnitude mask and the second less important set of components being the phase component are placed together along the channel direction and are input into the second neural network that calculates, in contrast to the first neural network, and input with two channels while the first neural network 340 calculates an input with a single channel only.

When the $DNN_M$ 340 in Fig. 12 performs a splitting and concatenating along the channel dimension with an overlap, it has to be checked that the overlap is also generated in the second subset fed into the combiner 350 so that a combination of stacked results from the network 340 and correspondingly stacked results of the second subset can be done in the combiner 350. Alternatively the output of network 350 is processed in such a way that the overlap due to the splitting along the channel direction is eliminated so that the second subset fed into the combiner 350 matches with the output of network 350 to perform the combination illustrated in Fig. 13 or in Fig. 12.

Generally, the number of channels processed by the later neural network is higher than the number of channels processed by the lower order neural network, i.e., the neural network that is earlier in the processing cascade. A generalized situation of the neural network processor 300 is illustrated in Fig., 11, where three neural networks 340, 360, and 380 are illustrated, where neural network 340 is the most complex neural network, and neural network 360 is of medium complexity and neural network 380 is of lowest complexity. At the same time, the number of channels processed by the first neural network 340 is lower than the number of channels processed by the second neural network 360 and the number of channels processed by the last neural network 380 is the highest when the combiners 350, 370 always perform a concatenation along the channel as illustrated in Fig. 13.

Fig. 12 illustrates an embodiment with only two neural networks 340, 360 where the output of the second neural network 360 is a representation with a real component and an imaginary component, while the combined input into neural network 360 is the magnitude and the phase arranged along the channel direction as illustrated in Fig. 13.

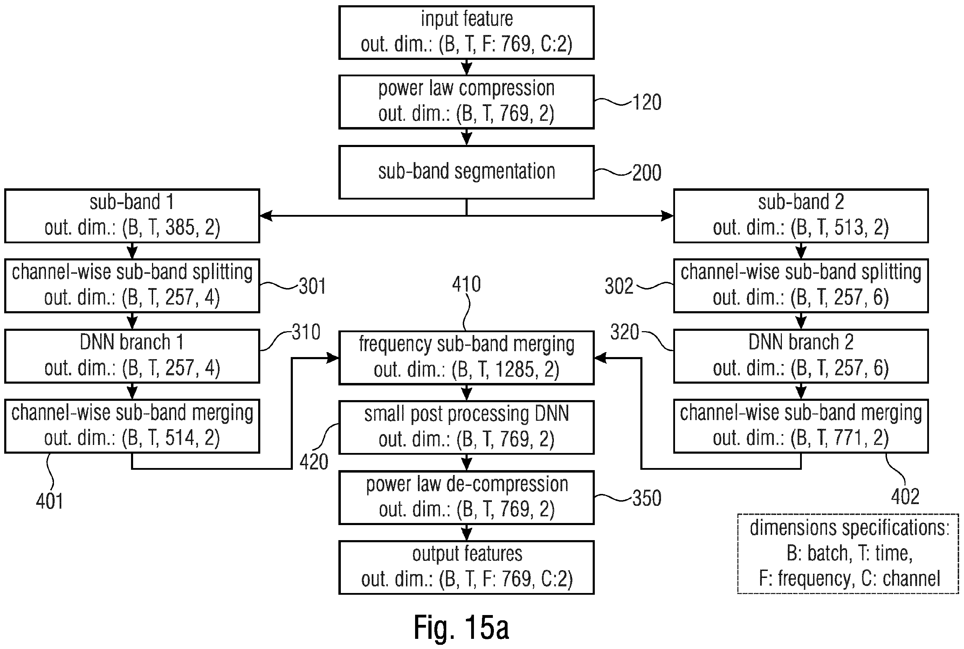

Preferably, the cascaded processing with two different networks having different complexities is preferred for implementations illustrated in Fig. 16 and Fig. 17, where the subband segmentation 200 and the corresponding frequency subband merging 410 illustrated in Fig. 15a which requires two parallel neural networks 310, 320 is not processed. However, an additional channel-wise subband splitting 301 and a corresponding channel-wise subband merging or stacking 401 as illustrated, for example, in Fig. 17, is preferably combined with the sequential or cascaded processing illustrated in Fig. 11 and Fig. 12, so that the main DNN 330 of Fig. 17 is implemented as illustrated in Fig. 11 and Fig. 12, i.e., by means of the processing illustrated with reference number 340 to 380 or 340 to 360.

In a variety of applications related to DNN based signal processing, the input features can potentially be decomposed/divided into multiple components. Additionally, all the components need not be equally important in the context of the target task. In such cases, the DNN based processing pipeline can be decomposed into multi-stage processing with each stage dealing with the processing of the components with reducing importance in the context of the task at hand. If each subsequent stage deals with new but less relevant/important input information, the DNN modules in such a design can also be of declining computational complexity.

A block diagram of such a processing pipeline is shown in Fig. 11. The input feature in this case can be decomposed into N components and numbered according to importance/relevance for the task. As shown, the first DNN only takes the most important/relevant feature component as the input and produces an intermediate output which is then combined with the second most important/relevant feature to be given as input to the next DNN which is of lower complexity than the first one. This processing chain is continued for all the N components of the input feature, with output of the $N^{th}$ DNN considered as the final output.

For a more specific description, one may consider the application of noise reduction and using STFT as the feature extraction step. The idea can also be applied for other signal processing tasks where the extracted feature can be decomposed into two or more individual components, e.g., in image processing for certain enhancement tasks it might be preferable to process the foreground and background of the image separately in two stages.

In the case of STFT, which is a complex transform, the feature representation can be decomposed into magnitude and phase components, i.e.,

$$X = X_m * e^{-jX_p}$$

where, $X_m$ and $X_p$ are the magnitude and phase components of the complex STFT representation. For the specific case of noise reduction, it is generally more critical to enhance the magnitude component. This fact is utilized to further reduce the complexity of the overall system.

Recognizing the importance of the magnitude component, in the first stage of the processing, shown in the left part of Fig. 12, a DNN model ($DNN_M$) is used to estimate a magnitude mask that can be used to enhance the magnitude component of the input feature. This model can be designed to be of much lower complexity than a model that operates on both the complex components of the input feature together. The computed magnitude mask is then combined with the phase component of the input feature at this stage.

If the dimensions of the magnitude mask and the phase component are the same, the combination can be a simple concatenation of the two components along the channel dimension as shown in Fig. 13.

Alternatively, the phase can be combined with the magnitude to obtain the real and imaginary components separately, e.g.,

$$Y_R = M_M{}^* \cos(X_P),$$

$$Y_I = M_M{}^* \sin(X_P),$$

where $Y_R$ and $Y_I$ are the real and imaginary components of the intermediate output, $M_M$ is the obtained magnitude mask from $DNN_M$ and $X_P$ is the phase component of the original input feature.

Once computed, the real and imaginary components can also be concatenated along the channel dimension as shown in Fig. 13 to form the input to the next stage.

In the next stage (c.f. Fig. 12), the intermediate combined magnitude mask and phase component is processed using another DNN model ($DNN_{MP}$) to obtain the real and imaginary components of the final enhanced output signal which is then provided to the inverse transform to obtain the enhanced audio signal. Since, in this second stage the main task is to enhance the phase, along with enhanced magnitude mask, a DNN model with even lower complexity than $DNN_M$ can be utilized to further reduce the computational complexity of the overall system.

Fig. 16 illustrates an implementation of a processing pipeline in accordance with the second aspect including power law compression 120 and power law de-compression 350. The DNN block can be implemented as illustrated in any of the figures of this application and can also be implemented as a straightforward neural network without subband segmentation, channel-wise subband splitting and corresponding merging methods such as channel wise subband merging and frequency subband merging. Such a DNN with sequential processing which includes, for example, convolutional layers, LSTMs and convolutional transposed layers for mask estimation related to noise reduction in a 48 kHz sampling frequency rate task may be implemented as illustrated in Fig. 16. Particularly, the frequency dimension will be 769 per time frame, and the channel number C will be equal to 2, since the input features are complex features and comprise a real part and an imaginary part or a magnitude and a phase.

It has been found that, depending on the batch number B, the time number T which can be selected as required, this DNN has shown to have a computational complexity of 499.5 MFlops (mega flops) with a parameter size of 2.67 M (millions). A major part of the computational complexity for this DNN architecture has been contributed by the convolutional and convolutional transpose layers as in the case the convolutional kernel needs to move through a high dimensional frequency axis which has, in the Fig. 16 embodiment, a value of F = 769. In such a situation, the present invention in accordance with the first aspect is highly beneficial. As the subband segmentation method segments the frequency axis feature with two overlap segments by reducing the frequency axis dimension, and the channel-wise subband splitting method further drastically reduces the frequency axis dimension of the segmented features by taking fixed overlap segments and stacking them in a channel dimension. The apparatus as illustrated in Fig. 15a is obtained with the corresponding frequency and channel numbers. It appears from Fig. 15a that, by means of the frequency dimension for the first subset is reduced from 769 to 385 and the frequency dimension of the second subset is reduced from 769 to 513. It is to be emphasized that the dimension is smaller for the first subband than compared to the second subband, and that the sum of the frequency dimension, i.e., 385 + 513 is equal to 898 frequency bins compared to 769 frequency bins illustrated in block 120 of Fig. 15a. This is due to the overlapping range.

Furthermore, as illustrated in Fig. 15a, for the lower subband, a two-times subband splitting is performed, while, for the higher subband, the three-fold subband splitting is performed. In the left branch of Fig. 15a, the channel number is increased from 2 to 4 indicating two segments while, in the right hand portion, the channel number is increased from 2 to 6 indicating three segments.

The corresponding merging in block 401 results in 257 x 2 = 514 frequency values. The right hand side results in 257 x 3 = 771 frequency values.

Subsequent to the frequency subband merging, the frequency dimension is as much as 1285 with a channel number of 2, and this dimension is reduced by the small post processing neural network 422, the input dimension of 769 with two channels, which is the same figure as in block 120.

The power law compression in block 350 does not change anything with respect to the dimension and, therefore, the output features as can be input into the post processor have a channel dimension of 769 with two channels for a real/imaginary or magnitude/phase representation.

In the above-mentioned system for the DNN branch 1 and 2, for comparison, the same DNN architecture that has been shown in Fig. 16 for the sequential system was used. However, the parallel system described in Fig. 15a has a computational complexity of 399.5 MFlops which is 100 MFlops less than the system described in Fig. 16. This is mainly due to the reduced frequency axis dimension of the input features which was a bottleneck in the sequential system, achieved by the Sub-band Segmentation and Channel Wise Sub-band Splitting method.

In practice, one can use two less complex separate DNNs for the DNN branch 1 and 2 compared to the DNNs used in Fig. 15a. This is because, after segmentation methods, the DNN needs to process much more localized overlapped features than the DNN employed in Fig. 16, so a simpler DNN can also do the task efficiently. Another reason is that in practice, the higher frequency bins contain low energy, so the higher frequencies add little to the subjective and objective improvement of e.g. the mask estimation for noise reduction task compared to the lower frequency bins, which contain higher energy, and, hence have more significance. So, the DNN employed in branch 2 can be even lesser complex than DNN branch 1.

Hence, two different DNNs for DNN branch 1 and 2 are used. The computational complexity for DNN branch 1 and 2 are respectively 112.5 MFlops and 96.3 MFlops with parameters size of 2.57M and 2.43M respectively. After merging methods, a small DNN of 25 MFlops computational complexity with 3.18M parameters is used.

Altogether this system has a computational complexity of 233.83MFLops with 8.17+M parameters. This shows a reduction of 265.67 MFlops complexity reduction compared to the sequential system described in Fig. 16, even after having almost 3 times parameters.

The performance of this system is also subjectively and objectively much better than the system described in Fig. 16. It is evident that the above-mentioned inventions make this a very computationally efficient system even without compromising the performance.

Fig. 15b shows a comparison of the complexity of the Fig. 16 embodiment and the Fig. 16a embodiment illustrating a drastic reduction of complexity measured in MFlops.

Fig. 17 illustrates another preferred embodiment that can be usable, for example, for an application with a reduced sampling rate. While, in the above description of Fig. 15a, a use case of an audio processing system for 48 kHz sampling rate was described, Fig. 17 illustrates a use case that can be applied for 16 kHz sampling rate, where the channel-wise subband splitting 301 along with the channel-wise subband merging 401 is used for a computational complexity reduction for this lower sampling rate. A 16 kHz sampling rate illustration is also illustrated in Fig. 16, but the Fig. 17 implementation shows an additional complexity reduction as is illustrated in the table of Fig. 18. Particularly, the frequency dimension of 257 is reduced by a three-times subband splitting in block 301 so that the channel number is increased from 2 to 6, and the frequency dimension of each channel 129 is at the number of 387, which is greater than 257 due to the overlap applied for the channel wise subband splitting 301. The channel wise subband merging illustrated in block 401 reduces the channel number by 3 and increases the frequency dimension to the maximum of 387 for the dimension of the frequency input feature. The small post-processing neural network 420 reduces the dimension from 387 to the original 257 as shown in block 120, and this number is not changed by the power law decompression procedure in block 350.

In this system the original input features have F=257 and C=2. The Channel Wise Sub-band Splitting method is implemented with a splitting window of 129 F bins and 64 bins overlap. So the output of the Channel Wise Sub-band Splitting block has a shape (B,T,129,6). This system has a computational complexity of 48.23MFlops. A similar system architecture without having this splitting and merging method will have a computational complexity of at least 150MFlops.

One can further reduce the computational complexity by just using smaller splitting window and overlap. In the lowest computationally complex model with this architecture (having minor changes in RNN layers) a splitting window of 65 F bins and 17 bins overlap was adopted. The output of the Channel Wise Sub-band Splitting block has a shape (B,T,65,10).

Generally, for the above examples, but also for other implementations, an overlap between the segments between 3 and 50 frequency bins has proven beneficial.

This system reduced to have a computational complexity of 24.93MFlops with minimal drop in subjective performance.

In this final section, the design choices related to the multi-stage processing, the reason for the choices and the complexity reduction achieved are described. The Channel Wise Sub-Band Splitting method from the previous section has its limitation for reducing the computational complexity. Smaller splitting window results in a greater number of channels, hence it is difficult for the main DNN to estimate the intermediate results.

Instead of using both the real and imaginary part separately, the input is split into magnitude and phase-based features. As for noise reduction task the magnitude is subjectively more significant, so the Channel Wise Sub-Band Splitting and Merging method is employed on magnitude and processed using a smaller $DNN_M$ as shown in Fig. 11. As magnitude is 1 dimensional so the input features dimension to the $DNN_M$ is (B,T,257,1). Since the input dimension was reduced to 1, a smaller splitting window can be introduced.

In a practical implementation, two different $DNN_M$ for two different systems are used. In one use case a splitting window of 48 frequency bins with an overlap of 18 bins was used. This resulted in a feature dimension of (B,T,48,8) after Channel Wise Sub-Band Splitting block. The $DNN_M$ employed for this system has a computational complexity of 4.62MFlops with a parameter size 0.684M. In another case, the $DNN_M$ employed has a computational complexity of 2.74MFlops with a parameter size 0.362M. In the latter system, a splitting window of 40 F bins with an overlap of 16 bins was used, which resulted in a feature dimension of (B,T,40,10).

For both cases, an even smaller DNN named $DNN_{Mp}$ was used to process the phase information fused with the intermediate output. The $DNN_{Mp}$ has a computational complexity of 1.73 MFlops with 3.4K parameters. This resulted in an overall computational complexity of the first system to be 6.36 MFlops and the latter system to be 4.48 MFlops.

The overall performance drop after employing this method is still in an acceptable range, but the computational complexity was reduced almost 30 times. This is very significant and enables to run the algorithm in embedded devices for a 16kHz sampling rate.

Subsequently, other embodiments of the invention, for example, for the first aspect are summarized as examples, wherein the reference numbers in brackets do not constitute any limitation of the general principle.

1. Apparatus for processing an information signal, comprising:

a feature extractor (100) for extracting a set of features from the information signal, the set of features having a first dimension;

a feature segmenter (200) for segmenting the set of features into a first subset of features and a second subset of features, the first subset of features having a second dimension and the second subset of features having a third dimension, wherein the second dimension and the third dimension are lower than the first dimension, and wherein the first subset and the second subset of features have an overlapping range, so that one or more features of the set of features are in the first subset of features and in the second subset of features;

a neural network processor (300) configured for processing the first subset using a first neural network (310) to obtain a first result and for processing the second subset of features using a second neural network (320) to obtain a second result;

a feature combiner (400) for combining the first result and the second result using a third neural network (420), the third neural network having a third complexity being lower than a first complexity of the first neural network (310) or a second complexity of the second neural network (320) to obtain a result set of features having a result dimension; and

an output post-processor (500) for post-processing the result set of features to obtain a processed information signal.

2. Apparatus of example 1, wherein the feature extractor (100) comprises a time-frequency decomposer for generating, from the information signal being in a time-domain representation, a decomposed signal being in a time-frequency representation comprising a sequence of time frames, each time frame having a number of frequency bins, and a feature set builder for building the set of features from the decomposed signal in the time-frequency representation,
wherein the output post-processor (500) comprises a frequency-time composer for composing, from an input set of features being in the time-frequency representation, the processed information signal being in the time domain representation, wherein the input set of features is the result set of features or is derived from the result set of features and the set of features.

3. Apparatus of example 2, wherein the result set of features is a time-frequency mask, and wherein the output post-processor (500) comprises a mask processor:

for applying the time-frequency mask to the set of features in the time-frequency representation to obtain the input set of features for the frequency-time composer, or

for calculating a processing filter from the time-frequency mask and for applying the processing filter to the information signal or the set of features to obtain the input set of features for the frequency-time composer.

4. Apparatus of one of the preceding examples, wherein the first neural network (310) is more complex than the second neural network (320), or wherein the first subset of features comprises information on the information signal from a lower frequency range of the information signal compared to the second subset of features comprising information of the information signal from a higher frequency range of the information signal.

5. Apparatus of example 4, wherein the feature segmenter (200) is configured to generate the first subset of features and the second subset of features, so that the second dimension is lower than the third dimension.

6. Apparatus of one of the preceding examples, wherein the neural network processor (300) is configured to split (302) the second subset of features into second multiple segments and to place the second multiple segments along a channel dimension to enhance a channel number of an input set to be input into the second neural network (320).

7. Apparatus of one of the preceding examples, wherein the neural network processor (300) is configured to split the first subset of features into first multiple segments and to place the first multiple segments along a channel direction to enhance a channel number of an input set of be input into the first neural network (310).

8. Apparatus of example 6 or 7, wherein a number of the second multiple segments is greater than the number of the first multiple segments, or wherein the segment size of the second multiple segments is the same among the second multiple segments, or wherein the segment size of the first multiple segments is the same among the first multiple segments, or wherein only the second subset is split and the subset is not split.

9. Apparatus of one of examples 6 to 8, wherein the neural network processor (300) is configured to split the second or the first subset into overlapping segments.

10. Apparatus of example 9, wherein an overlapping amount of the segments is between 1/5 of a segment width and 4/5 of the segment width.

11. Apparatus of one of the preceding examples, wherein the feature combiner (400) comprises a stacker (402) to perform a stacking of the second result of the second neural network (320) or to perform a stacking (101) of the first result of the first neural network (310) to obtain a stacked set of features; and
wherein the third neural network is configured for receiving, as an input, the stacked set of features and to output the result set of features, wherein the stacked set of features has a higher dimension than the result set.

12. Apparatus of example 11, wherein the stacker (401, 402) is configured to generate the stacked set by placing input sets of features into an order, wherein a dimension of the stacked set is greater than the mention of the set of features obtained by the feature extractor (100), and
wherein the third neural network (420) is configured to generate the result set of features having the result dimension being lower than the dimension of the stacked set.

13. Apparatus of one of the preceding examples, wherein the apparatus is configured as an embedded device, or wherein the apparatus is included in an embedded device, or wherein the first neural network (310) and the second neural network (320) are configured to operate, in a hardware implementation, in parallel, or wherein the result dimension is greater than the second dimension or the third dimension.

14. Apparatus of one of the preceding examples, wherein the information signal input into the feature extractor has a sampling rate being greater than 16 kHz,

wherein the feature extractor (100) comprises a time-frequency decomposer generating at least for each time frame, 300 frequency bins, or

wherein the overlapping range comprises at least 40 frequency bins.

15. Method of processing an information signal, comprising:

extracting a set of features from the information signal, the set of features having a first dimension;

segmenting the set of features into a first subset of features and a second subset of features, the first subset of features having a second dimension and the second subset of features having a third dimension, wherein the second dimension and the third dimension are lower than the first dimension, and wherein the first subset and the second subset of features have an overlapping range, so that one or more features of the set of features are in the first subset of features and in the second subset of features;

processing the first subset using a first neural network (310) to obtain a first result and processing the second subset of features using a second neural network (320) to obtain a second result;

combining the first result and the second result using a third neural network (420), the third neural network having a third complexity being lower than a first complexity of the first neural network (310) or a second complexity of the second neural network (320) to obtain a result set of features having a result dimension; and

post-processing the result set of features to obtain a processed information signal.

16. Computer program for performing, when running on a computer or a processor, the method of example 15.

Subsequently, other embodiments of the invention, for example, for the third aspect are summarized as examples, wherein the reference numbers in brackets do not constitute any limitation of the general principle.

1. Apparatus for processing an information signal, comprising:

a feature extractor (100) for extracting a set of features from the information signal, wherein each feature of the set of features comprises at least two feature components, and wherein the set of features comprises a first subset with the first feature components and a second subset with the second feature components; and

a neural network processor (300) comprising:

a first neural network (340) for receiving, as an input, the first subset and for outputting a processed first subset;

a combiner (350) for combining the processed first subset and the second subset to obtain a combined subset; and

a second neural network (360) for receiving, as an input, the combined subset and for outputting a processed combined output,

wherein the processed combined output represents a processed information signal, or

wherein the apparatus is configured to calculate the processed information signal using the processed combined output, and

wherein a complexity of the first neural network (340) is greater than a complexity of the second neural network.

2. Apparatus of example 1, wherein the information signal is an audio signal, wherein the feature extractor (100) comprises a time-frequency decomposer for calculating a time-frequency domain representation of the audio signal, wherein the first subset comprises magnitude values of the time-frequency representation and the second subset comprises phase values of the time-frequency representation, or wherein a first feature component of the at least two feature components is more important than a second feature component of the at least two feature components.

3. Apparatus of one of the preceding examples, wherein the combiner (350) is configured to concatenate the processed first subset and the second subset along a channel direction, and wherein the first neural network is configured to process the first subset with a first number of channels being 1 or greater than 1, and wherein the second neural network (360) is configured to process the combined subset with a second number of channels, wherein the second number of channels is greater than the first number of channels.

4. Apparatus of example 3, wherein the second number of channels is greater than the first number of channels by 1.

5. Apparatus of one of the preceding examples, wherein the first subset comprises magnitude values, and wherein the second subset comprises phase values, and

wherein the processed first subset comprises magnitude values, and

wherein the combiner (350) is configured to calculate, for each component of the processed first subset and the second subset, a real part component and an imaginary part component, and

wherein the second neural network (360) is configured to received, as the combined subset, a subset comprising real part components and the imaginary part components.

6. Apparatus of example 5, wherein the first subset comprises magnitude values of the set of features, and wherein the set of features comprises complex frequency bin entries,

wherein the first neural network (340) is configured to calculate the processed first subset so that the processed first subset represents a time frequency mask only having magnitude values for the frequency bins, and

wherein the combiner (350) is configured to combine the magnitude mask values for the frequency bins and phase values of the complex frequency bin entries for corresponding frequency bins, so that a magnitude mask value of a frequency bin is combined with a phase value of the complex frequency bin entry of the same frequency bin.

7. Apparatus of one of the preceding examples, wherein the neural network processor (300) is configured to

perform a channel-wise splitting (301, 302) of the first subset into M multiple segments,

wherein the first neural network (340) is configured to receive the first subset concatenated along a channel direction with M channels and to output the processed first subset, and

wherein the neural network processor (300) is configured to combine the first processed subset concatenated along the channel direction (420) into a single channel representation as the first processed subset.

8. Apparatus of example 7, wherein the M multiple segments comprise two, three or more segments, wherein the three or more segments are overlapping segments, and wherein an overlap between the overlapping segments is greater than 3 frequency bins and lower than 50 frequency bins.

9. Apparatus of example 7, wherein the neural network processor (300) is configured to perform the channel-wise subband splitting (301, 302) into the M overlapping segments of the first subset and wherein the processed first subset has M channels, and

wherein the neural network processor (300) is configured to perform a channel wise subband splitting of the second subset into M overlapping segment and to arrange the second subset into M channels, and

wherein the combiner (350) is configured to perform the processing of the first subset and the second subset, so that the combined subset comprises two times M channels.

10. Apparatus of example 9, wherein the second neural network (360) is configured to process the combined subset having two times M channels to obtain an output of the second neural network (360), and wherein the neural network process (300) is configured to stack (401, 402) and combine a stacked set of features into the processed combined output having a dimension similar to a dimension of the set of features extracted by the feature extractor (100).

11. Apparatus of one of the preceding examples, wherein the complexities of the first neural network (340) and the second neural network (360) are measured in floating point operations (FLOPS), wherein a higher number of floating point operations represents a higher complexity, or in execution time on one or more target hardware(s), wherein a higher execution time represents a higher complexity, or in power consumption of a certain device, wherein a higher power consumption represents a higher complexity, or a number or MAC (Multiply and Accumulate) operations, wherein a higher number of MAC operations represents a higher complexity.

12. Apparatus of one of the preceding examples, wherein the feature extractor (100) comprises:

a raw feature calculator (110) for calculating raw feature results, wherein each raw feature result has at least two raw feature components; and

a raw feature compressor (120) for performing a compression of the at least two raw feature components to obtain at least two compressed raw feature components for each raw feature result, wherein the first subset comprises first features of the at least two raw feature components of the raw feature results, and wherein the second subset comprises the second raw feature components of the at least two raw feature components of the raw feature results.

13. Apparatus of one of the preceding examples, wherein the information signal comprises an audio signal, an image signal, or a radar signal.

14. Apparatus of one of the preceding examples, wherein the apparatus is configured as an embedded device, or wherein the first neural network (340) and the second neural network (360) are configured to operate in series to each other.

15. Method of processing an information signal, comprising:

extracting a set of features from the information signal, wherein each feature of the set of features comprises at least two feature components, and wherein the set of features comprises a first subset with the first feature components and a second subset with the second feature components; and

using a neural network processor (300) comprising:

a first neural network (340) for receiving, as an input, the first subset and for outputting a processed first subset;

a combiner (350) for combining the processed first subset and the second subset to obtain a combined subset; and

a second neural network (360) for receiving, as an input, the combined subset and for outputting a processed combined output,

wherein the processed combined output represents a processed information signal, or wherein the apparatus is configured to calculate the processed information signal using the processed combined output, and

wherein a complexity of the first neural network (340) is greater than a complexity of the second neural network.

16. Computer program for performing, when running on a computer or a processor, the method of example 15.

It is to be mentioned that all alternatives or aspects as discussed before and all aspects as defined by independent claims in the following claims can be used individually, i.e., without any other alternative or object than the contemplated alternative, object or independent claim. However, in other embodiments, two or more of the alternatives or the aspects or the independent claims can be combined with each other and, in other embodiments, all aspects, or alternatives and all independent claims can be combined with each other.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

Depending on certain implementation requirements, embodiments of the invention can be implemented in hardware or in software. The implementation can be performed using a digital storage medium, for example a floppy disk, a DVD, a CD, a ROM, a PROM, an EPROM, an EEPROM or a FLASH memory, having electronically readable control signals stored thereon, which cooperate (or are capable of cooperating) with a programmable computer system such that the respective method is performed.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier or a non-transitory storage medium.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

References

[1] Yu, G., Guan, Y., Meng, W., Zheng, C., & Wang, H. (2022). DMF-Net: A decoupling-style multi-band fusion model for full-band speech enhancement.

[2] Zhang, Xu, Lianwu Chen, Xiguang Zheng, Xinlei Ren, Chen Zhang, Liang Guo and Bin Yu. "A Two-Step Backward Compatible Fullband Speech Enhancement System." ICASSP 2022 - 2022 IEEE International Conference on Acoustics, Speech and Signal Processing (ICASSP) (2022): 7762-7766.

[3] S. Zhao, B. Ma, K. N. Watcharasupat and W. -S. Gan, "FRCRN: Boosting Feature Representation Using Frequency Recurrence for Monaural Speech Enhancement," ICASSP 2022 - 2022 IEEE International Conference on Acoustics, Speech and Signal Processing (ICASSP), 2022, pp. 9281-9285, doi: 10.1109/ICASSP43922.2022.9747578.

[4] Liu, Haohe, Lei Xie, Jian Wu and Geng Yang. "Channel-wise Subband Input for Better Voice and Accompaniment Separation on High Resolution Music." ArXiv abs/2008.05216 (2020): n. pag.

[5] Lv, Shubo, Yihui Fu, Mengtao Xing, Jiayao Sun, Lei Xie, Jun Huang, Yannan Wang and Tao Yu. "S-DCCRN: Super Wide Band DCCRN with Learnable Complex Feature for Speech Enhancement." ICASSP 2022 - 2022 IEEE International Conference on Acoustics, Speech and Signal Processing (ICASSP) (2022): 7767-7771.

**Claims**

1. Apparatus for processing an information signal, comprising:

   a feature extractor (100) for extracting a set of features from the information signal, wherein the feature extractor (100) comprises:

      a raw feature calculator (110) for calculating raw feature results, each raw feature result having at least two raw feature components; and
      a raw feature compressor (120) for performing a compression of a dynamic range to the at least two raw feature components to obtain at least two compressed raw feature components for each raw feature result, wherein the set of features comprises the compressed raw feature components; and

   a signal processor (600) for processing the set of features to obtain the processed information signal, wherein the information signal comprises an audio signal, an image signal, or a radar signal.

2. Apparatus of claim 1, wherein the raw feature calculator (110) is configured to calculate a complex value as the raw feature result, the raw feature result having a real part and an imaginary part or a magnitude and a phase, as the at least two raw feature components, and
   wherein the raw compressor (120) is configured to perform a compression of the real part and the imaginary part or the magnitude and the phase to obtain the compressed raw feature components.

3. Apparatus of claim 1 or 2, wherein the raw feature compressor (120) is configured to apply (121) a first compression function to a first raw feature component and to apply (122) a second compression function to a second raw feature component, the second compression function being different from the first compression function.

4. Apparatus of one of the preceding claims, wherein the performing compression comprises to apply (121,122) a power law compression using a power value, wherein the power value is lower than 1.

5. Apparatus of claim 4, wherein the power value is different for each raw feature component, or

   wherein the feature extractor (110) is configured to provide, for a specific information signal or for a specific processing task performed by the signal processor (600), one or more different numbers, or
   wherein the feature extractor (100) is configured to provide, for a specific information signal or for a specific processing task performed by the signal processor (600) one or more different numbers being derived by a specific training for the specific information signal or the specific processing task performed by the signal processor (600).

6. Apparatus of one of the preceding claims, wherein the raw feature calculator (110) is configured to calculate the raw feature components as absolute numbers and associated signs, and
wherein the raw feature compressor (120) is configured to apply a compression function to the absolute numbers and to retain the signs of the corresponding components.

7. Apparatus of one of the preceding claims, wherein the information signal is the audio signal, wherein the raw feature calculator (110) is configured to perform a time-frequency decomposition for decomposing the audio signal into a time-frequency representation, or
wherein the information signal is the image signal, and wherein the raw feature calculator (110) comprises the performing of a spatial transform for decomposing the image signal into a spatial frequency representation.

8. Apparatus of one of the preceding claims, wherein the signal processor (600) comprises:

a neural network processor (20, 300) for processing the set of features to obtain a processed set of features;
a feature decompressor (350) for performing a decompression matching with the compression performed by the raw feature compressor (120) to obtain a result set of features; and
a post-processor (500) for post-processing the result set of features to obtain the processed information signal.

9. Apparatus of claim 8, wherein the neural network processor (300) is configured to spilt (301, 302) the set of features into multiple segments and to place the multiple segments along the channel dimension to enhance a channel number from at least 2 to a number greater than two or to a number being an integer multiple of 2, and
wherein the neural network processor (300) comprises a neural network configured for receiving, as an input, the multiple segments as input channels and to generate, as an output, a number of output channels, wherein the neural network processor is configured to stack (401, 402) the output channels to obtain a stacked set of features.

10. Apparatus of claim 9, wherein the neural network processor (300) is configured to perform a feature combination (400) of the stacked set of features using a further neural network (420) having a complexity being smaller than the complexity of the neural network.

11. Apparatus of claim 10, wherein the neural network processor (300) is configured to split (301, 302) the set of features into overlapping segments, wherein the stacked set of features has a higher dimension compared to the dimension of the set of features, and wherein the further neural network (420) is configured to reduce the dimension of the stacked set of features to the dimension of the set of features or to a dimension being lower than the dimension of the set of features.

12. Apparatus of one of the preceding claims, wherein the information signal is an audio signal,

wherein a sample rate of the audio signal is lower than 24kHz,
wherein a dimension of the set of features in a frequency dimension is lower than 500 and greater than 200 and a channel number is 2 for the two raw feature components,
wherein the number of segments is between two and four and the number of channels is between four and eight, and
wherein an overlap of the segments is between 30 and 90 frequency bins.

13. Apparatus of one of the preceding claims, wherein the signal processor comprises one or more neural networks for processing the set of features to obtain the processed information signal.

14. Apparatus of one of the preceding claims,

wherein the signal processor (600) comprises a neural network processor (300) for processing the set of features comprising the compressed raw feature components, wherein the neural network processor (300) is configured to output result set of features,
wherein the apparatus comprises a feature decompressor for performing a decompression matching with the compression performed by the raw feature compressor (120) to obtain a decompressed result set of features,
wherein the decompressed result set of features is a time-frequency mask, and
wherein the signal processor (600) comprises a mask processor for applying the time-frequency mask as a spectral gain mask to the set of features extracted by the raw feature calculator (110) and a representation of the processed information signal, or for calculating a processing filter from the time-frequency mask and for applying the processing filter to the audio signal or the set of features calculated by the raw feature calculator (110) to obtain a representation of the processed information signal.

15. Method of processing an information signal, comprising:

extracting a set of features from the information signal, comprising:

calculating raw feature results, each raw feature result having at least two raw feature components; and
performing a compression of a dynamic range to the at least two raw feature components to obtain at least two compressed raw feature components for each raw feature result, wherein the set of features comprises the compressed raw feature components; and

processing the set of features to obtain the processed information signal, wherein the information signal comprises an audio signal, an image signal, or a radar signal.

16. Computer program for performing, when running on a computer or processor, the method of claim 15.

Fig. 1a

information signal
(audio signal,
image signal,
radar signal)

feature extractor

raw feature calculator ～110

$1^{st}$ component
(mag.,
real part…)

$2^{nd}$ component
(phase,
imaginary part…)

～100

raw feature compressor ～120

compressed
components

signal processor
(e.g. one or more neural networks,
feature segmenter, combiner,
post-processor, …)

～600

processed
information signal

Fig. 1b

EP 4 439 555 A1

Fig. 1c

27

10

P1
input
pre-
processing

20

D1
DNN
processing

30

P2
output
post-
processing

audio input → P1 → D1 → P2 → audio output

## Fig. 2

P1

100

input
feature
computation

200

CR1
feature
reorientation
for complexity
reduction

audio input → 100 → 200 → input to DNN

## Fig. 3a

P2

400

CR2
feature
reorientation
to original
dimensions

500

inversion
of feature
extraction
step

DNN output → 400 → 500 → audio output

## Fig. 3b

CR1

200

input feature → frequency subband segmentation

channel-wise frequency sub-band splitting → inputs to DNN

301

302

channel-wise frequency sub-band splitting →

## Fig. 4

D1

input feature

DNN 1 → 

310

320

DNN M →

DNN output

## Fig. 5

Fig. 6

Fig. 7

Fig. 8

Fig. 9

time frames

## Fig. 10

⬡ combination operation

## Fig. 11

Fig. 12

Fig. 13

2$^{nd}$ raw feature component    1$^{st}$ raw feature component

121 ⟋    apply 1$^{st}$ compression function to 1$^{st}$ component    $\alpha = \alpha_1$

compressed 1$^{st}$ component + sign of 1$^{st}$ raw feature component

122 ⟋    apply 2$^{nd}$ compression function to 2$^{nd}$ component    $\alpha = \alpha_2$

compressed 2$^{nd}$ component + sign of 2$^{nd}$ raw feature component

Fig. 14a

neural network processor —300

feature decompressor —350

feature combiner    feature decompressor → to 500

400    350

Fig. 14b

input feature
out. dim.: (B, T, F: 769, C:2)

power law compression
out. dim.: (B, T, 769, 2) — 120

sub-band segmentation — 200

sub-band 1
out. dim.: (B, T, 385, 2)

channel-wise sub-band splitting
out. dim.: (B, T, 257, 4) — 301

DNN branch 1
out. dim.: (B, T, 257, 4) — 310

channel-wise sub-band merging
out. dim.: (B, T, 514, 2) — 401

sub-band 2
out. dim.: (B, T, 513, 2)

channel-wise sub-band splitting
out. dim.: (B, T, 257, 6) — 302

DNN branch 2
out. dim.: (B, T, 257, 6) — 320

channel-wise sub-band merging
out. dim.: (B, T, 771, 2) — 402

frequency sub-band merging
out. dim.: (B, T, 1285, 2) — 410

small post processing DNN
out. dim.: (B, T, 769, 2) — 420

power law de-compression
out. dim.: (B, T, 769, 2) — 350

output features
out. dim.: (B, T, F: 769, C:2)

dimensions specifications:
B: batch, T: time,
F: frequency, C: channel

Fig. 15a

|  | MFlops | parameters (millions) |
|---|---|---|
| Fig. 16 | 499.5 MFlops | 2.67 |
| Fig. 15a | 233.83 MFlops | 8.17 |

## Fig. 15b

```
input feature
out. dim.: (B, T, F: 769, C:2)

power law compression          ~120
out. dim.: (B, T, 769, 2)

DNN                            300, 330,
out. dim.: (B, T, 769, 2)      340-380, 20

power law de-compression       ~350
out. dim.: (B, T, 769, 2)

output features
out. dim.: (B, T, F: 769, C:2)
```

## Fig. 16

```
┌─────────────────────────────────┐
│          input feature          │
│  out. dim.: (B, T, F: 257, C:2) │
└─────────────────────────────────┘
                │
                ▼
┌─────────────────────────────────┐
│      power law compression      │
│     out. dim.: (B, T, 257, 2)   │  ~120
└─────────────────────────────────┘
                │
                ▼
┌─────────────────────────────────┐
│  channel-wise sub-band splitting │
│     out. dim.: (B, T, 129, 6)   │  ~301
└─────────────────────────────────┘
                │
                ▼
┌─────────────────────────────────┐
│            main DNN              │
│     out. dim.: (B, T, 129, 6)   │  ~330, 340-380
└─────────────────────────────────┘
                │
                ▼
┌─────────────────────────────────┐
│  channel-wise sub-band merging   │
│     out. dim.: (B, T, 387, 2)   │  ~401
└─────────────────────────────────┘
                │
                ▼
┌─────────────────────────────────┐
│     small post processing DNN    │
│     out. dim.: (B, T, 257, 2)   │  ~420
└─────────────────────────────────┘
                │
                ▼
┌─────────────────────────────────┐
│     power law de-compression     │
│     out. dim.: (B, T, 257, 2)   │  ~350
└─────────────────────────────────┘
                │
                ▼
┌─────────────────────────────────┐
│          output features         │
│  out. dim.: (B, T, F: 257, C:2) │
└─────────────────────────────────┘
```

## Fig. 17

|                  | channels | MFlops |
|------------------|----------|--------|
| original Fig. 16 | 2        | 150    |
| CWS: 6 channels  | 6        | 48.23  |
| CWS: 10 channels | 10       | 24.93  |

## Fig. 18

Europäisches
Patentamt

European
Patent Office

Office européen
des brevets

## EUROPEAN SEARCH REPORT

Application Number

EP 23 16 5194

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 115 116 456 A (TENCENT TECH SHENZHEN CO LTD) 27 September 2022 (2022-09-27) | 1-8, 12-16 | INV. G10L21/02 |
| A | * paragraph [0002] * <br> * paragraph [0066] - paragraph [0071]; figure 2 * <br> * paragraph [0088] - paragraph [0121]; figure 4 * <br> ----- | 9-11 | G10L25/30 H03M7/30 G06N3/045 |
| A | Anonymous: "Modified discrete cosine transform", Wikipedia, 30 May 2003 (2003-05-30), pages 1-4, XP055445276, Retrieved from the Internet: URL:https://en.wikipedia.org/w/index.php?title=Modified_discrete_cosine_transform&oldid=978214 [retrieved on 2018-01-26] * the whole document * <br> ----- | 1-16 | |
| A | Anonymous: "Convolutional neural network - Wikipedia", , 8 November 2021 (2021-11-08), XP055943023, Retrieved from the Internet: URL:https://en.wikipedia.org/w/index.php?title=Convolutional_neural_network&oldid=1054217311#Convolutional_layer [retrieved on 2022-07-15] * Part titled "Hierarchical coordinate frames" * <br> ----- | 1-16 | TECHNICAL FIELDS SEARCHED (IPC) <br> G10L H03M G06N |

-/--

The present search report has been drawn up for all claims

| Place of search | Date of completion of the search | Examiner |
|---|---|---|
| The Hague | 7 August 2023 | De Ceulaer, Bart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

**EP 23 16 5194**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LIU YANG ET AL: "Multi-Modal Speech Separation Based on Two-Stage Feature Fusion", 2021 IEEE 6TH INTERNATIONAL CONFERENCE ON SIGNAL AND IMAGE PROCESSING (ICSIP), IEEE, 22 October 2021 (2021-10-22), pages 800-805, XP034073080, DOI: 10.1109/ICSIP52628.2021.9688674 [retrieved on 2022-01-20] * the whole document * | 1-16 | |
| A | KRISTINA TESCH ET AL: "Insights Into Deep Non-linear Filters for Improved Multi-channel Speech Enhancement", ARXIV.ORG, CORNELL UNIVERSITY LIBRARY, 201 OLIN LIBRARY CORNELL UNIVERSITY ITHACA, NY 14853, 16 January 2023 (2023-01-16), XP091414079, DOI: 10.1109/TASLP.2022.3221046 * Part III.D. * | 1-16 | |
| | | | TECHNICAL FIELDS SEARCHED (IPC) |

The present search report has been drawn up for all claims

| Place of search | Date of completion of the search | Examiner |
|---|---|---|
| The Hague | 7 August 2023 | De Ceulaer, Bart |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 5194

This annex lists the patent family members relating to the patent documents cited in  the above-mentioned European search report.
The members are as contained in the European Patent Office EDP file on
The European Patent Office is in no way liable for these particulars which are merely given for the purpose of information.

07-08-2023

| Patent document cited in search report | Publication date | Patent family member(s) | Publication date |
|---|---|---|---|
| CN 115116456 A | 27-09-2022 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YU, G. ; GUAN, Y. ; MENG, W. ; ZHENG, C. ; WANG, H.** *DMF-Net: A decoupling-style multi-band fusion model for full-band speech enhancement,* 2022
- **ZHANG, XU ; LIANWU CHEN ; XIGUANG ZHENG ; XINLEI REN ; CHEN ZHANG ; LIANG GUO ; BIN YU.** A Two-Step Backward Compatible Fullband Speech Enhancement System. *ICASSP 2022 - 2022 IEEE International Conference on Acoustics, Speech and Signal Processing (ICASSP),* 2022, 7762-7766
- **S. ZHAO ; B. MA ; K. N. WATCHARASUPAT ; W. -S. GAN.** FRCRN: Boosting Feature Representation Using Frequency Recurrence for Monaural Speech Enhancement. *ICASSP 2022 - 2022 IEEE International Conference on Acoustics, Speech and Signal Processing (ICASSP),* 2022, 9281-9285

- **LIU, HAOHE ; LEI XIE ; JIAN WU ; GENG YANG.** Channel-wise Subband Input for Better Voice and Accompaniment Separation on High Resolution Music. *ArXiv abs/2008.05216,* 2020
- **LV, SHUBO ; YIHUI FU ; MENGTAO XING ; JIAYAO SUN ; LEI XIE ; JUN HUANG ; YANNAN WANG ; TAO YU.** S-DCCRN: Super Wide Band DCCRN with Learnable Complex Feature for Speech Enhancement. *ICASSP 2022 - 2022 IEEE International Conference on Acoustics, Speech and Signal Processing (ICASSP),* 2022, 7767-7771